# EUROPEAN PATENT APPLICATION

(11) **EP 4 495 987 A2**
(43) Date of publication of application: **22.01.2025**
(21) Application number: 24186783.7
(22) Date of filing: 05.07.2024
(51) Int. Cl.: H01L 21/8234, H01L 27/088, H01L 29/06, H01L 29/66, H01L 29/775, H01L 29/786

(54) **SEMICONDUCTOR DEVICES**

(30) Priority: 21.07.2023 KR 20230095404
(71) Applicant: Samsung Electronics Co., Ltd., Suwon-si, Gyeonggi-do 16677 (KR)
(72) Inventor: KIM, Hyojin, 16677 Suwon-si (KR); HWANG, Donghoon, 16677 Suwon-si (KR); KANG, Myungil, 16677 Suwon-si (KR)
(74) Representative: Marks & Clerk LLP

(57) **Abstract**

A semiconductor device includes gate structures (300) on an insulation structure (140, 420), the gate structures disposed in a second direction (D2) substantially parallel to an upper surface of the insulation structure, source/drain layers at opposite sides, respectively, of each gate structure in a first direction (D1) intersecting the second direction, semiconductor patterns (134) disposed in a third direction (D3) substantially perpendicular to the upper surface of the insulation structure, the semiconductor patterns extending through each of the gate structures and contacting the source/drain layers, a first division pattern (150) between the gate structures, and a connection pattern (370) extending into and contacting an upper portion of the first division pattern and upper portions of the gate structures adjacent to the first division pattern, a lower surface of the connection pattern being lower than upper surfaces of the gate structures and an upper surface of the connection pattern being higher than the upper surfaces of the gate structures.

## Description

### BACKGROUND

Example embodiments relate to semiconductor devices.

In a logic device, a gate structure is formed to extend in a direction, and a division pattern is formed to divide the gate structure into a plurality of parts in the direction. Some of the plurality of parts of the gate structure are connected with each other by a connection pattern.

Thus, a method of easily forming the division pattern and the connection pattern is needed.

### SUMMARY

It is an aspect to provide a semiconductor device having enhanced characteristics.

According to an aspect of one or more example embodiments, there is provided a semiconductor device comprising gate structures on an insulation structure, the gate structures being disposed in a second direction substantially parallel to an upper surface of the insulation structure; source/drain layers at opposite sides, respectively, of each of the gate structures in a first direction substantially parallel to the upper surface of the insulation structure and intersecting the second direction; semiconductor patterns disposed in a third direction substantially perpendicular to the upper surface of the insulation structure, the semiconductor patterns extending through each of the gate structures and contacting the source/drain layers; a first division pattern between the gate structures; and a connection pattern extending into and contacting an upper portion of the first division pattern and upper portions of the gate structures adjacent to the upper portion of the first division pattern, a lower surface of the connection pattern being lower than upper surfaces of the gate structures and an upper surface of the connection pattern being higher than the upper surfaces of the gate structures.

According to another aspect of one or more example embodiments, there is provided a semiconductor device comprising gate structures on a substrate, the gate structures being disposed in a second direction substantially parallel to an upper surface of the substrate, and each of the gate structures including a gate insulation pattern and a gate electrode; source/drain layers at opposite sides, respectively, of each of the gate structures in a first direction that is substantially parallel to the upper surface of the substrate and that intersects the second direction; semiconductor patterns disposed in a third direction substantially perpendicular to the upper surface of the substrate, the semiconductor patterns extending through each of the gate structures and contacting the source/drain layers; a first division pattern between the gate structures; and a connection pattern contacting an upper surface of the first division pattern and upper surfaces of portions of the gate structures that are adjacent to the upper surface of the first division pattern, wherein the gate insulation pattern extends in the third direction, covers upper surfaces and lower surfaces of each of the semiconductor patterns, a sidewall in the second direction of each of the semiconductor patterns and a sidewall of a portion of the first division pattern between the semiconductor patterns, and wherein the gate insulation pattern contacts a lower surface of the connection pattern.

According to yet another aspect of one or more example embodiments, there is provided a semiconductor device comprising gate structures on an insulation structure, the gate structures being disposed in a second direction substantially parallel to an upper surface of the insulation structure; a capping pattern on the gate structures; source/drain layers at opposite sides, respectively, of each of the gate structures in a first direction that is substantially parallel to the upper surface of the insulation structure and that intersects the second direction; semiconductor patterns disposed in a third direction substantially perpendicular to the upper surface of the insulation structure, the semiconductor patterns extending through each of the gate structures and contacting the source/drain layers; first division patterns and second division patterns between the gate structures, the first division patterns and the second division patterns being spaced apart from each other in the second direction and dividing the gate structures in the second direction; a first contact plug on each of the source/drain layers; a connection pattern extending through the capping pattern and commonly contacting corresponding adjacent ones of the gate structures, a lower surface of the connection pattern being lower than upper surfaces of the gate structures and an upper surface of the connection pattern being higher than the upper surfaces of the gate structures; a first via on the first contact plug; a second via on the connection pattern; and a second contact plug on a portion of the gate structures on which the connection pattern is not provided.

At least some of the above and other features of the invention are set out in the claims.

### BRIEF DESCRIPTION OF THE DRAWINGS

FIGS. 1 to 4 are a plan view and cross-sectional views illustrating a semiconductor device in accordance with example embodiments.
FIGS. 5 to 40 are plan views and cross-sectional views illustrating a method of manufacturing a semiconductor device in accordance with example embodiments.
FIG. 41 is a cross-sectional view illustrating a semiconductor device in accordance with example embodiments.
FIGS. 42 to 44 are cross-sectional views illustrating a semiconductor device in accordance with example embodiments.

### DETAILED DESCRIPTION

Hereinafter, a semiconductor device and a method for manufacturing the same in accordance with example embodiments will be described in detail with reference to the accompanying drawings. It will be understood that, although the terms "first," "second," and/or "third" may be used herein to describe various elements, the various elements should not be limited by these terms. Rather, the terms "first," "second," and/or "third" are only used to distinguish one element from another element.

In the specification (and not necessarily in the claims), two directions among horizontal directions that are substantially parallel to an upper surface of a substrate, which may intersect each other, may be referred to as a first direction D1 and a second direction D2, and a vertical direction that is substantially perpendicular to the upper surface of the substrate may be referred to as a third direction D3. In some example embodiments, the first and second directions D1 and D2 may be substantially perpendicular to each other.

In the semiconductor device in accordance with various example embodiments, some of the gate structures spaced apart from each other in a direction may be electrically connected to each other by a connection pattern commonly contacting the upper surfaces of the gate structures, and thus an electrical signal may be commonly applied thereto.

In some example embodiments, an upper surface of a contact plug contacting source/drain layers that are adjacent to each of the gate structures may be substantially coplanar with an upper surface of the connection pattern, and thus a via on the upper surface of the connection pattern and the contact plug may be spaced apart from each other by a given distance, so that process margin for forming the via and the contact plug may increase.

In some example embodiments, the connection pattern may not be formed on the entire upper surfaces of the gate structures, but may have a given length in a direction of the gate structures, so that a parasitic capacitance between the connection pattern and the contact plug may decrease.

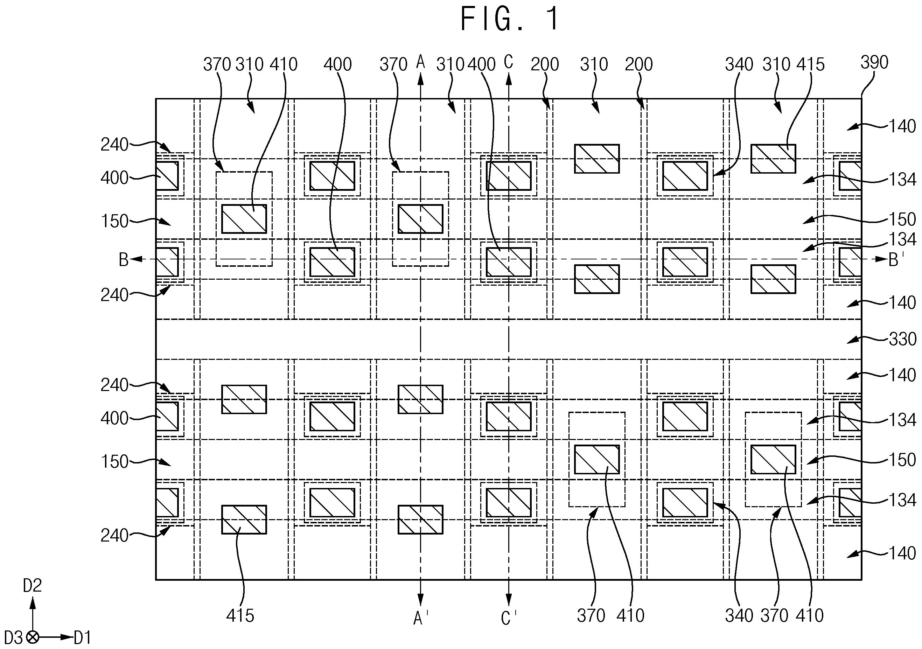

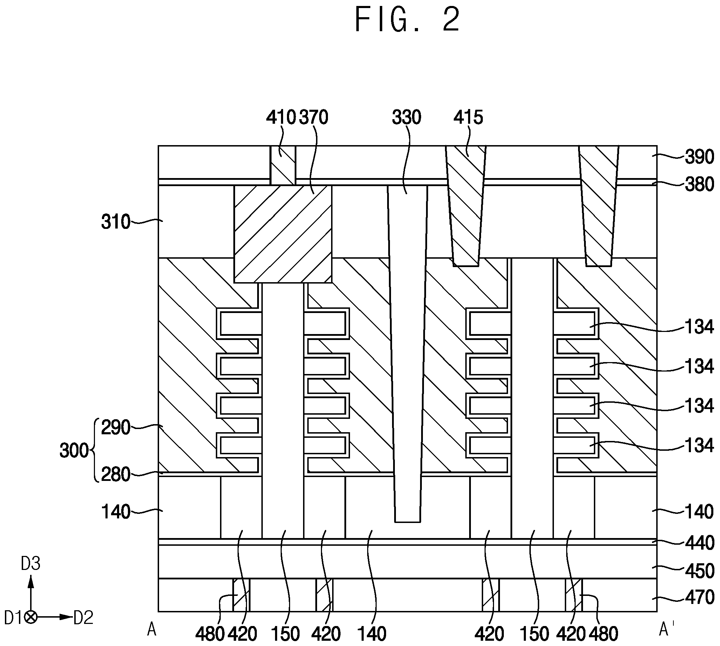

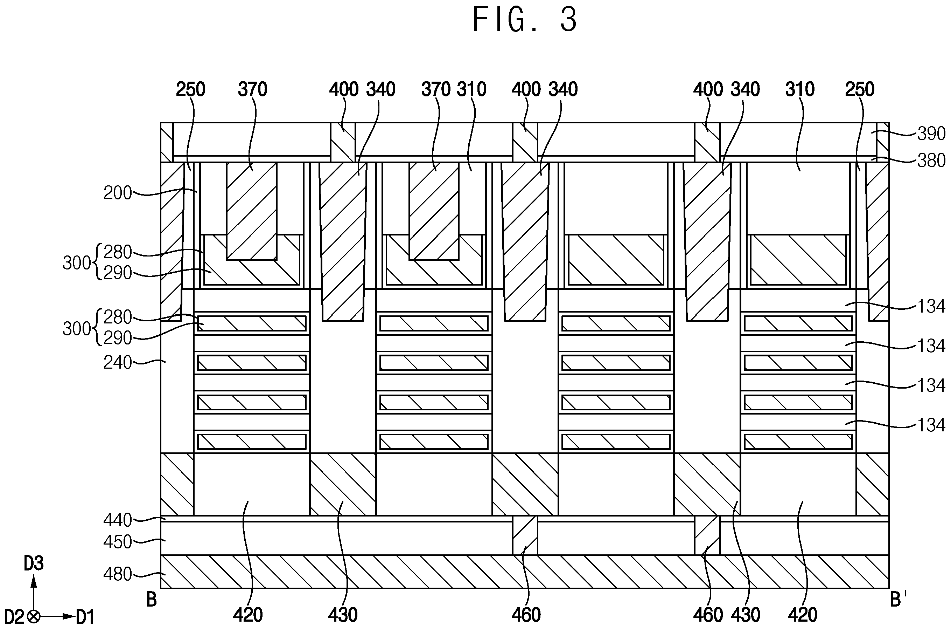

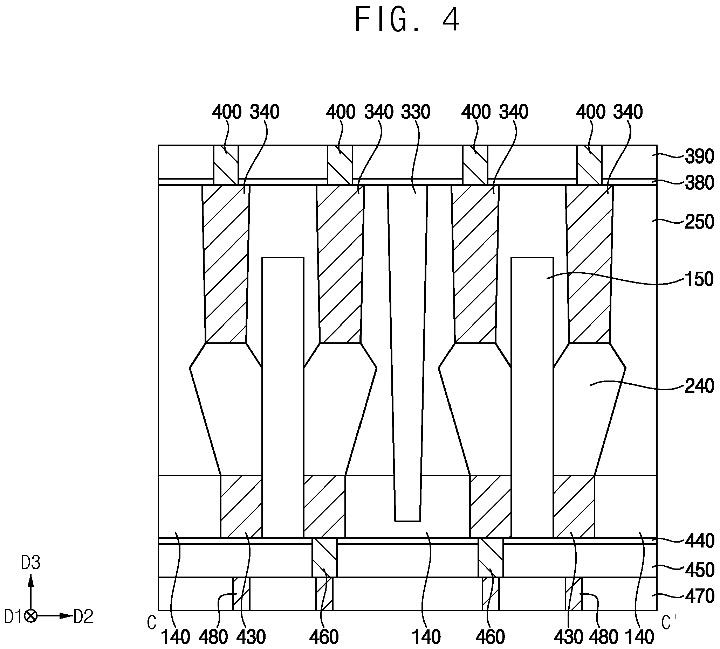

FIGS. 1 to 4 are a plan view and cross-sectional views illustrating a semiconductor device in accordance with example embodiments. Particularly, FIG. 1 is the plan view, FIG. 2 is a cross-sectional view taken along line A-A' in FIG. 1, FIG. 3 is a cross-sectional view taken along line B-B' in FIG. 1, and FIG. 4 is a cross-sectional view taken along line C-C' in FIG. 1.

Referring to FIGS. 1 to 4, the semiconductor device may include a gate structure 300, a source/drain layer 240, a semiconductor pattern 134, a first division pattern 150 and a second division pattern 330 and a connection pattern 370.

The semiconductor device may further include a capping pattern 310, a gate spacer 200, a first contact plug 340, a second contact plug 415, and a third contact plug 430, a first via 400, a second via 410, and a third via 460, a first wiring 480, an isolation pattern 140, a second insulation pattern 420, a first insulating interlayer pattern 250, a fourth insulating interlayer 390, a fifth insulating interlayer 450, and a sixth insulating interlayer 470, and a second etch stop layer 380 and a third etch stop layer 440.

The sixth insulating interlayer 470, the fifth insulating interlayer 450 and the third etch stop layer 440 may be sequentially stacked in the third direction D3 (see FIGS. 2, 4).

Each of the fifth and sixth insulating interlayers 450 and 470 may include an oxide, e.g., silicon oxide or a low-k dielectric material, and the third etch stop layer 440 may include a nitride, e.g., silicon nitride.

In an example embodiment, the first wiring 480 may extend through the sixth insulating interlayer 470 in the first direction D1, and a plurality of first wirings 480 may be spaced apart from each other in the second direction D2. In an example embodiment, the first wiring 480 may be a power rail. In some example embodiments, the first wiring 480 may be a signal line.

The third via 460 may extend through the fifth insulating interlayer 450 and the third etch stop layer 440, and may contact the first wiring 480. In example embodiments, a plurality of third vias 460 may be spaced apart from each other in the first and second directions D1 and D2.

Each of the first wiring 480 and the third via 460 may include a conductive material, e.g., a metal, a metal nitride, a metal silicide, etc.

The isolation pattern 140 may be formed on the third etch stop layer 440, and may extend in the first direction D1. In example embodiments, a plurality of isolation patterns 140 may be spaced apart from each other in the second direction D2. The first division pattern 150 may be formed on the third etch stop layer 440, and may extend in the first direction D1. In example embodiments, a plurality of first division patterns 150 may be spaced apart from each other in the second direction D2.

In an example embodiment, a single first division pattern 150 may be disposed between neighboring ones of the isolation patterns 140 in the second direction D2. In some example embodiments, a plurality of first division patterns 150 may be disposed between neighboring ones of the isolation patterns 140 in the second direction D2.

In example embodiments, a width in the second direction D2 of the first division pattern 150 may be smaller than a width in the second direction D2 of the isolation pattern 140.

The second insulation pattern 420 may be formed on the third etch stop layer 440, and a plurality of second insulation patterns 420 may be spaced apart from each other in the first and second directions D1 and D2. In example embodiments, the second insulation pattern 420 may be disposed between neighboring ones of the isolation pattern 140 and the first division pattern 150 in the second direction D2 (see FIG. 2).

Each of the isolation pattern 140 and the second insulation pattern 420 may include an oxide, e.g., silicon oxide. However, , example embodiments are not limited thereto, and in some example embodiments, each of the isolation pattern 140 and the second insulation pattern 420 may include other insulating materials. In an example embodiment, the isolation pattern 140 and the second insulation pattern 420 may include substantially the same material, and may be merged with each other to form an insulation structure. The first division pattern 150 may include an insulating nitride, e.g., silicon nitride.

The third contact plug 430 may be formed on the third etch stop layer 440 and the third via 460, and may contact an upper surface of the third via 460. In example embodiments, a plurality of third contact plugs 430 may be spaced apart from each other in the first and second directions D1 and D2. For example, the plurality of third contact plugs 430 may be formed on the third etch stop layer 440. In some example embodiments, at least a portion of the plurality of third contact plugs 430 may be formed on third vias 460. For example, in the cross-sectional view illustrated in FIG. 4, inner third contact plugs 430 are formed on the third etch stop layer 440 and the third vias 460, and outer third contact plugs 430 are formed only on the third etch stop layer 440. In example embodiments, the third contact plug 430 may be disposed between neighboring ones of the isolation pattern 140 and the first division pattern 150 in the second direction D2, and a sidewall of the third contact plug 430 may contact a sidewall of the second insulation pattern 420 (see FIG. 3). Thus, the second insulation pattern 420 and the third contact plug 430 may be alternately and repeatedly disposed in the first direction D1.

The third contact plug 430 may include a conductive material, e.g., a metal, a metal nitride, a metal silicide, etc.

The gate structure 300 may be formed on the isolation pattern 140 and the second insulation pattern 420, and a plurality of gate structures 300 may be spaced apart from each other in the first and second directions D1 and D2. The first and second division patterns 150 and 330 may be disposed between neighboring ones of the gate structures in the second direction D2 (see FIG. 2). The second division pattern 330 may include an insulating nitride, e.g., silicon nitride.

The semiconductor pattern 134 may extend through the gate structure 300 in the first direction D1 to a given length, and a plurality of semiconductor patterns 134 may be spaced apart from each other in the third direction D3 (see FIGS. 2, 3). In example embodiments, a sidewall in the second direction D2 of the semiconductor pattern 134 may contact a sidewall in the second direction D2 of the first division pattern 150 (see FIG. 2).

In an example embodiment, a thickness in the third direction D3 of an uppermost one of the semiconductor patterns 134 may be greater than thicknesses in the third direction D3 of other underlying ones of the semiconductor patterns 134. For example, each the underlying ones of the plurality of semiconductor patterns 134 may have a thickness in the third direction D3 and the thickness may be less than the thickness in the third direction D3 of the uppermost one of the semiconductor patterns 134. However, example embodiments are not limited thereto. The semiconductor pattern 134 may include a semiconductor material, e.g., silicon, germanium, etc.

The gate structure 300 may include an upper portion on the uppermost one of the semiconductor patterns 134 and a lower portion under and contacting the upper portion thereof. In example embodiments, a width in the first direction D1 of the upper portion of the gate structure 300 may be smaller than a width in the first direction D1 of the lower portion of the gate structure 300 (best seen in FIG. 3).

The capping pattern 310 may be formed on upper surfaces of the gate structure 300 and the first division pattern 150, and each of opposite sidewalls in the second direction D2 of the capping pattern 310 may contact the second division pattern 330. The capping pattern 310 may include an insulating nitride, e.g., silicon nitride. In an example embodiment, the capping pattern 310 may include a material substantially the same as a material of the second division pattern 330, and thus may be merged with the second division pattern 330.

The gate spacer 200 may contact an upper surface of each of opposite edge portions in the first direction D1 of the uppermost one of the semiconductor patterns 134, and may cover each of opposite sidewalls in the first direction D1 of the upper portion of the gate structure 300 and each of opposite sidewalls in the first direction D1 of the capping pattern 310 (see FIG. 3). The gate spacer 200 may include an insulating nitride, e.g., silicon nitride.

The gate structure 300 may include a gate insulation pattern 280 and a gate electrode 290.

In example embodiments, the gate insulation pattern 280 may contact upper surfaces of the second insulation pattern 420 and the isolation pattern 140, upper and lower surfaces and a sidewall in the second direction D2 of each of the semiconductor patterns 134, a portion of a sidewall in the second direction D2 of the first division pattern 150, and a lower portion of an inner sidewall in the first direction D1 of the gate spacer 200.

The gate electrode 290 may be formed in a space between the second insulation pattern 420 and a lowermost one of the semiconductor patterns 134, a space between the semiconductor patterns 134, and a space over the uppermost one of the semiconductor patterns 134 in the third direction D3 (see FIGS. 2, 3). The gate electrode 290 may be formed in a space adjacent to a sidewall in the second direction D2 of the second division pattern 330 on the isolation pattern 140 (best seen in FIG. 2). A surface of the gate electrode 290, except for an upper surface and a portion of a sidewall thereof, may be covered by the gate insulation pattern 280.

In some embodiments, an interface pattern may be formed on the upper surface of the second insulation pattern 420, the upper and lower surfaces and the sidewall in the second direction D2 of each of the semiconductor patterns 134.

The interface pattern may include an oxide, e.g., silicon oxide, and the gate insulation pattern 280 may include a metal oxide having a high dielectric constant, e.g., hafnium oxide, tantalum oxide, zirconium oxide, etc.

In an example embodiment, the gate electrode 290 may include a work function control pattern and a metal pattern sequentially stacked on the gate insulation pattern 280. The work function control pattern may include, e.g., titanium nitride, titanium oxynitride, tantalum nitride, tantalum oxynitride, tungsten nitride, tungsten carbonitride, aluminum oxide, etc., and the metal pattern may include a metal, e.g., titanium, aluminum, etc., or an alloy thereof.

In example embodiments, the second division pattern 330 may extend through an upper portion of the isolation pattern 140 in the first direction D1, and may be disposed between and divide neighboring ones of the gate structures 300 in the second direction D2. The second division pattern 330 may contact a sidewall in the second direction D2 of each of the gate electrodes 290. The second division pattern 330 may extend through the capping pattern 310, and may contact a sidewall in the second direction D2 of the capping pattern 310.

The source/drain layer 240 may be formed on the third contact plug 430, and may commonly contact each of opposite sidewalls in the first direction D1 of the semiconductor patterns 134 to be electrically connected thereto. The source/drain layer 240 may also contact a sidewall of the lower portion of the gate structure 300. In an example embodiment, an inner spacer including an insulating nitride, e.g., silicon nitride, may be formed between the source/drain layer 240 and the sidewall of the lower portion of the gate structure 300.

In an example embodiment, an uppermost surface of the source/drain layer 240 may be substantially coplanar with an upper surface of the uppermost one of the semiconductor patterns 134 (see FIG. 3). However, example embodiments are not limited thereto.

In an example embodiment, a cross-sectional view in the second direction D2 of the source/drain layer 240 may have a shape of, e.g., a hexagon. The source/drain layer 240 may include silicon-germanium doped with p-type impurities, e.g., boron, gallium, indium, etc., and may serve as a source/drain of a PMOS transistor. In some example embodiments, the cross-sectional view in the second direction D2 of the source/drain layer 240 may have a shape of, e.g., a pentagon.

In some example embodiments, a cross-sectional view in the second direction D2 of the source/drain layer 240 may have a shape of, e.g., a rectangle with rounded corners. The source/drain layer 240 may include silicon or silicon carbide doped with n-type impurities, e.g., phosphorus, arsenic, etc., and may serve as a source/drain of an NMOS transistor.

The gate structure 300, the semiconductor pattern 134 and the source/drain layers 240 may collectively form a transistor, and the semiconductor pattern 134 may serve as a channel of the transistor. In example embodiments, a plurality of semiconductor patterns 134 may be disposed in the third direction D3 in a single gate structure 300, and thus the semiconductor device may include a multi-bridge channel field effect transistor (MBCFET). Each of the semiconductor patterns 134 may be surrounded by the gate structure 300, and thus the transistor may be a gate all around (GAA) type transistor.

The connection pattern 370 may extend through upper portions of the gate structures 300 disposed in the second direction D2, an upper portion of the first division pattern 150 therebetween, and the capping pattern 310, and may electrically connect the gate structures 300 with each other.

In example embodiments, a width in the first direction D1 of the connection pattern 370 may be smaller than a width in the first direction D1 of the gate structure 300 (see FIGS. 1, 3). In example embodiments, the connection pattern 370 may extend through only a portion of the gate structure 300 adjacent to the first division pattern 150 in the second direction D2 (see FIG. 2), and thus a portion of the gate structure 300 distal to the first division pattern 150 in the second direction D2 may not contact the connection pattern 370.

In example embodiments, an upper surface of the connection pattern 370 may be substantially coplanar with upper surfaces of the capping pattern 310, the gate spacer 200 and the second division pattern 330 (see FIGS. 2, 3).

FIGS. 1 to 4 show that the connection pattern 370 electrically connects gate structures 300 at opposite sides, respectively, of the first division pattern 150 to each other only in some of gate structure pairs including gate structures 300 disposed at the opposite sides, respectively, of the first division pattern 150. For example, in the cross-section illustrated in FIG. 2, the connection pattern 370 electrically connects gate structures 300 on opposite sides, respectively, of the first division pattern 150 on the left hand side, but no connection pattern 370 is provided on the right hand side. However, , example embodiments are not limited thereto. In some example embodiments, the connection pattern 370 may electrically connect gate structures 300 at opposite sides, respectively, of the first division pattern 150 to each other in all of gate structure pairs.

FIGS. 1 to 4 show that a single first division pattern 150 is disposed at each of opposite sides in the second direction D2 of the second division pattern 330, and two gate structures 300 are disposed at opposite sides, respectively, of the first division pattern 150, and the connection pattern 370 contacts and connects upper portions of the two gate structures 300 adjacent to each other in the second direction D2. However, example embodiments are not limited thereto. For example, a plurality of first division patterns 150 may be disposed between neighboring ones of the second division patterns 330 in the second direction D2, and two gate structures 300 may be disposed at opposite sides, respectively, of each of the first division patterns 150, and the connection pattern 370 may contact and connect upper portions of a plurality of gate structures 300 disposed in the second direction D2.

The first insulating interlayer pattern 250 may be formed on the isolation pattern 140, and may cover the source/drain layer 240. The first insulating interlayer pattern 250 may contact an outer sidewall of the gate spacer 200 that is disposed on a sidewall of the upper portion of the gate structure 300 and a sidewall of the capping pattern 310. An upper surface of the first insulating interlayer pattern 250 may be substantially coplanar with the upper surfaces of the capping pattern 310, the gate spacer 200, the connection pattern 370 and the second division pattern 330. The first insulating interlayer pattern 250 may include an oxide, e.g., silicon oxide, or a low-k dielectric material.

The first contact plug 340 may extend through the first insulating interlayer pattern 250, and may contact the source/drain layer 240. In some example embodiments, the first contact plug 340 may extend through an upper portion of the source/drain layer 240. In example embodiments, an upper surface of the first contact plug 340 may be substantially coplanar with the upper surface of the connection pattern 370.

The second etch stop layer 380 and the fourth insulating interlayer 390 may be sequentially stacked on the capping pattern 310, the gate spacer 200, the first insulating interlayer pattern 250 and the first contact plug 340.

The first via 400 may extend through the second etch stop layer 380 and the fourth insulating interlayer 390, and may contact the upper surface of the first contact plug 340. The second via 410 may extend through the second etch stop layer 380 and the fourth insulating interlayer 390, and may contact the upper surface of the connection pattern 370. The second contact plug 415 may extend through the capping pattern 310, the second etch stop layer 380 and the fourth insulating interlayer 390, and may contact the upper surface of the gate electrode 290.

Each of the first and second contact plugs 340 and 415 and the first and second vias 400 and 410 may include a conductive material, e.g., a metal, a metal nitride, a metal silicide, etc. The second etch stop layer 380 may include an insulating nitride, e.g., silicon nitride. The fourth insulating interlayer 390 may include an oxide, e.g., silicon oxide or a low-k dielectric material.

The semiconductor device may further include an upper wiring serving as a signal line or a power rail that may be formed on the fourth insulating interlayer 390, the second contact plug 415 and the first and second vias 400 and 410 to contact upper surfaces of the second contact plug 415 and the first and second vias 400 and 410.

As illustrated above, in the semiconductor device, the gate structures 300 may be disposed in the first and second directions D1 and D2, and the first and second division patterns 150 and 330 may be disposed between the gate structures 300 disposed in the second direction D2 to divide the gate structures 300 from each other.

In example embodiments, some neighboring gate structures 300 neighboring in the second direction D2 (i.e., some gate structure pairs) may be electrically connected to each other by the connection pattern 370 extending through the upper portions thereof. However, in some example embodiments, the connection pattern 370 may not necessarily extend through the upper portions of the gate structures 300, but a lower surface of the connection pattern 370 may be substantially coplanar with and contact the upper surfaces of the gate structures 300.

The upper surface of the connection pattern 370 may be substantially coplanar with the upper surface of the first contact plug 340. Thus, as best seen in FIG. 1, a distance between the connection pattern 370 and the first via 400 on the upper surface of the first contact plug 340 may be provided, and a distance between the first contact plug 340 and the second via 410 on the connection pattern 370 may be provided. Accordingly, process margin for forming the first and second vias 400 and 410 and the first contact plug 340 may increase.

The connection pattern 370 may contact only some neighboring gate structures disposed in the second direction D2 so as to have a relatively small length in the second direction D2. Thus, when compared to a related art case in which a connection pattern having a linear shape is disposed on an entire portion of the gate structures 300 to overlap the first contact plug 340 in the horizontal direction, a parasitic capacitance between the connection pattern 370 and the first contact plug 340 may decrease.

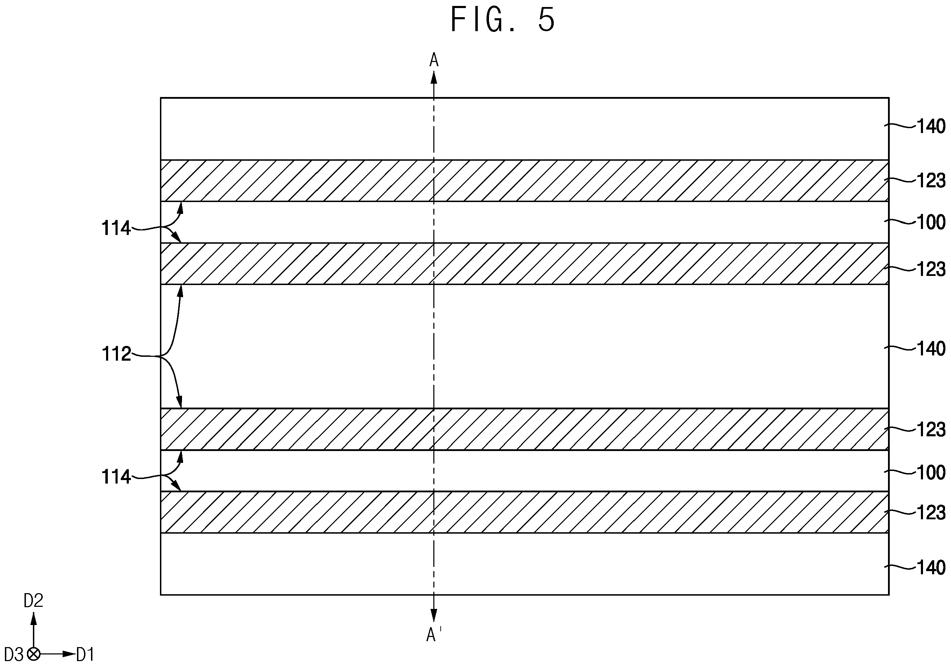

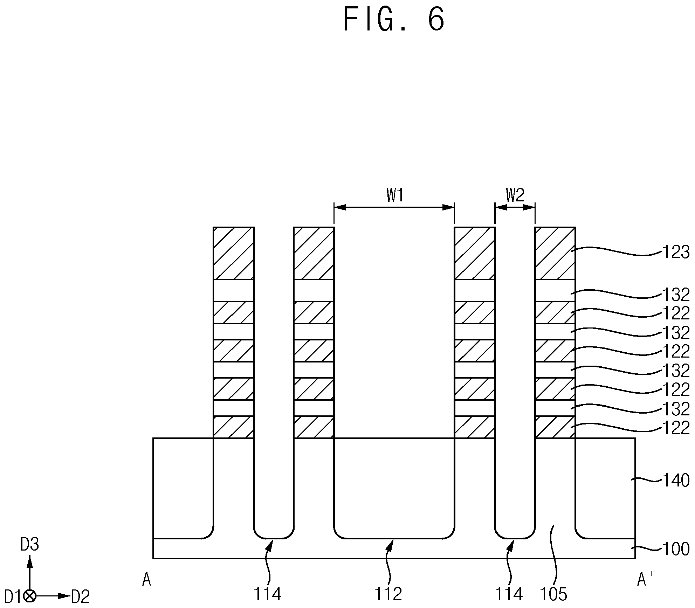

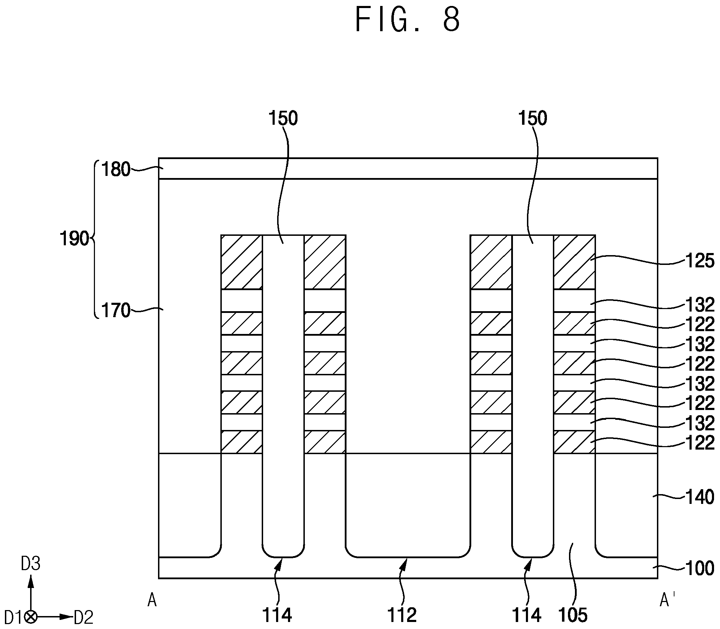

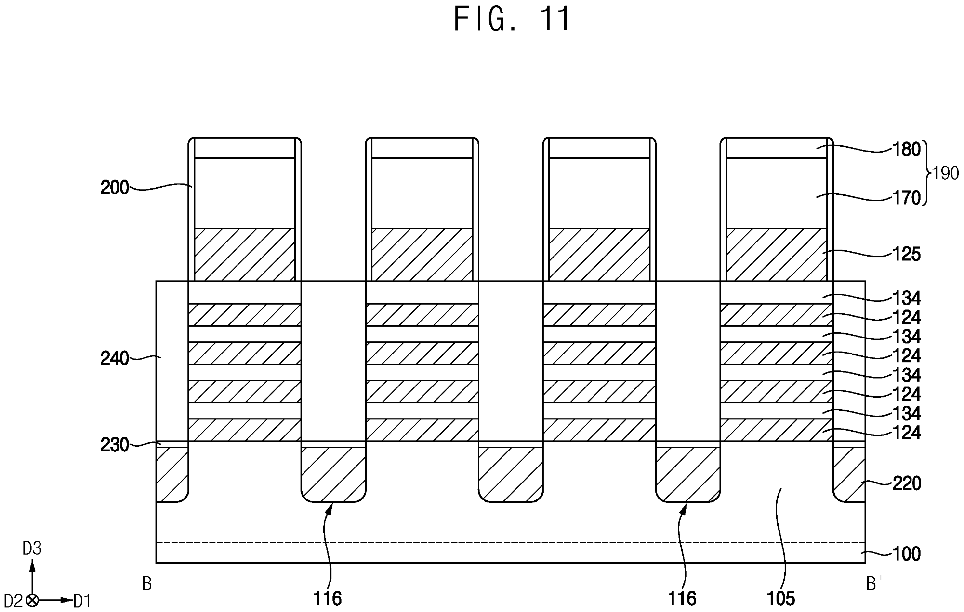

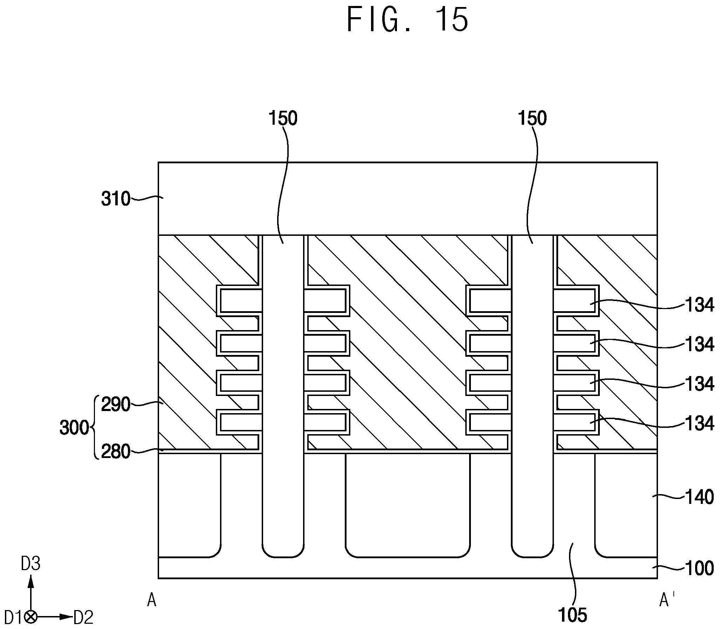

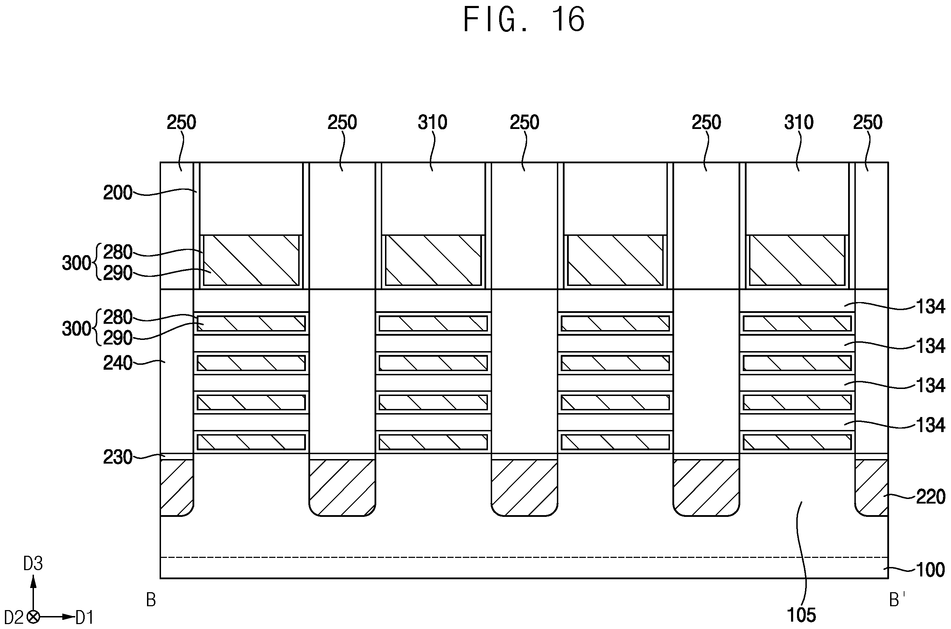

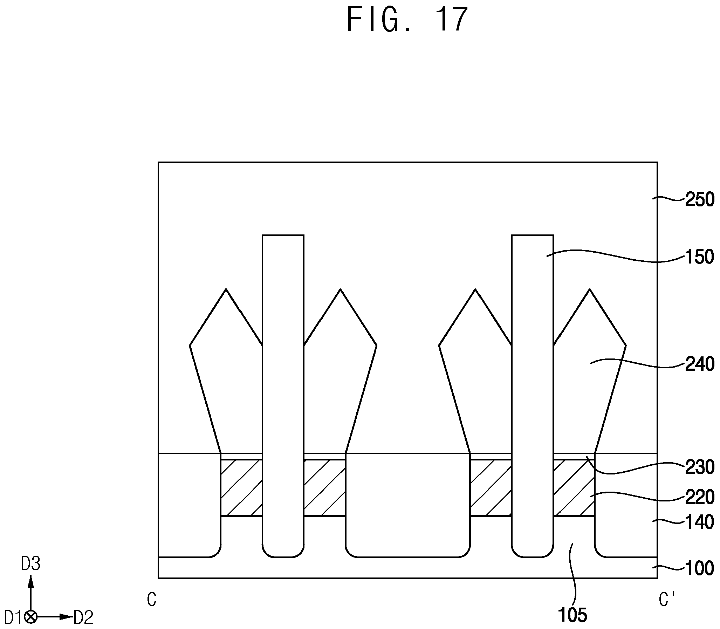

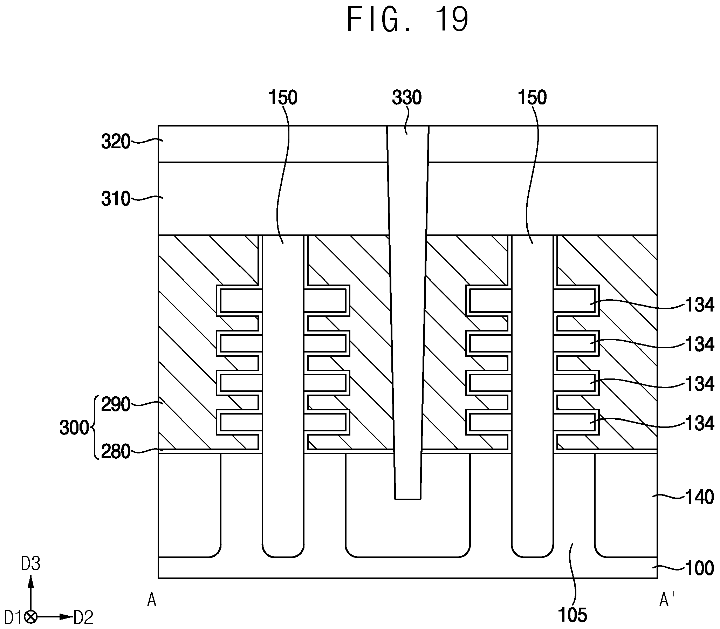

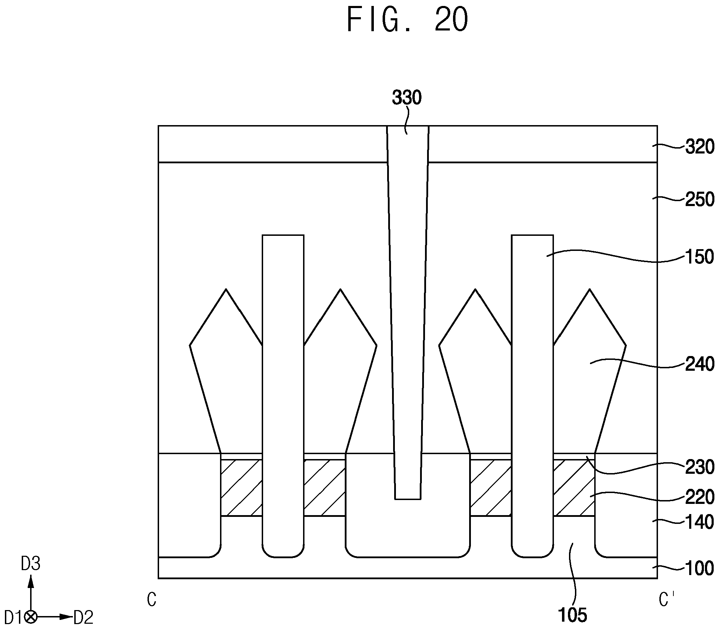

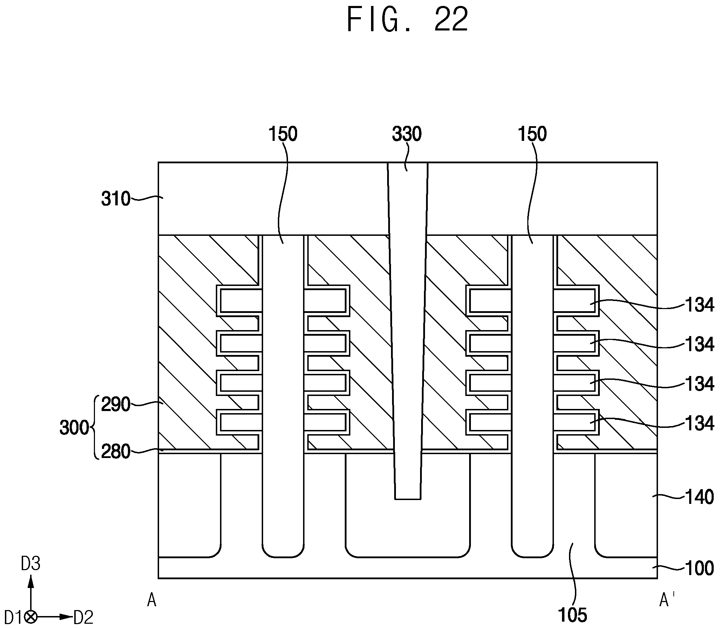

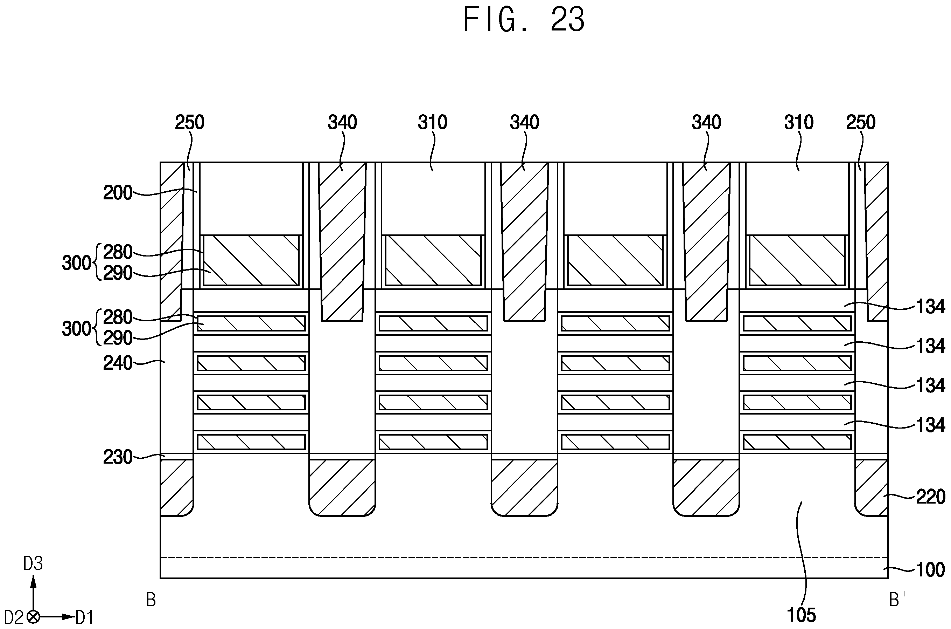

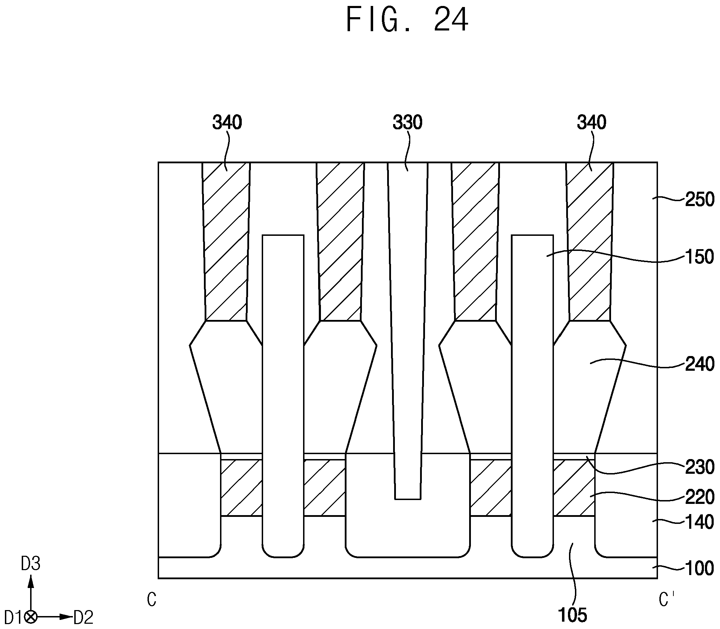

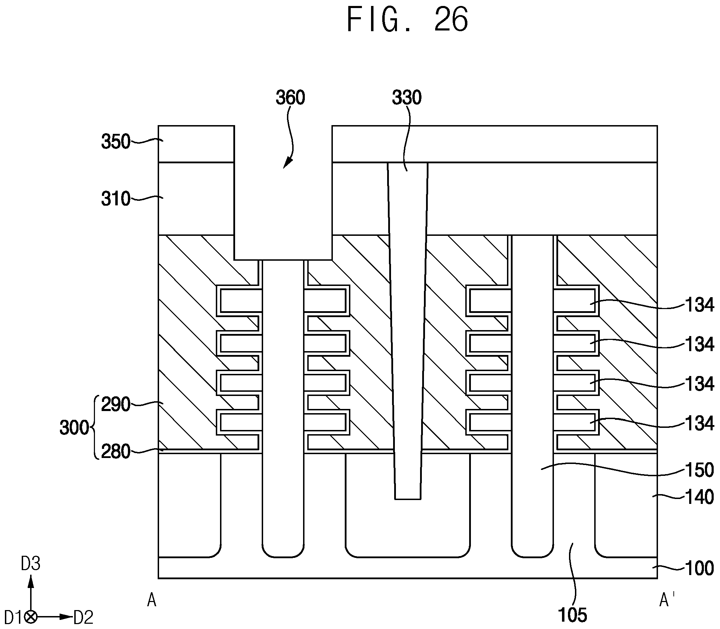

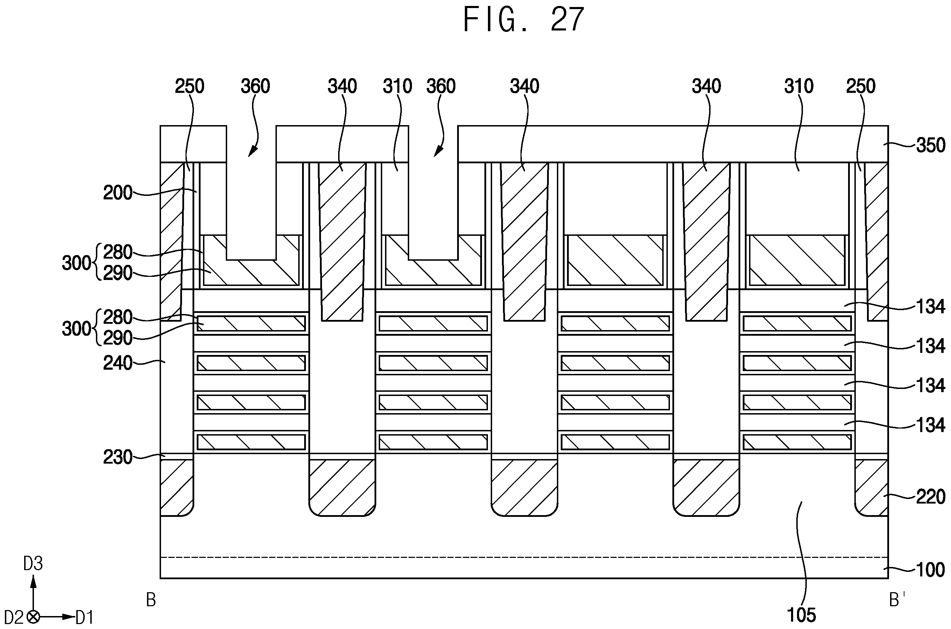

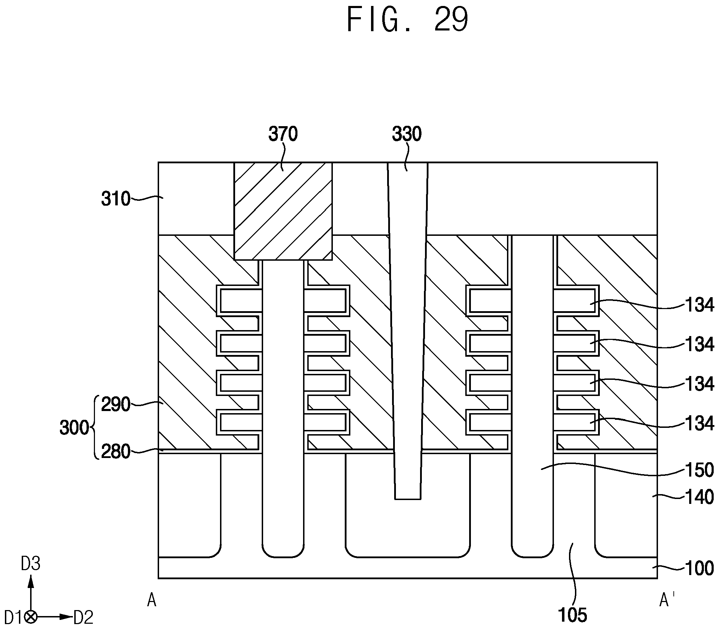

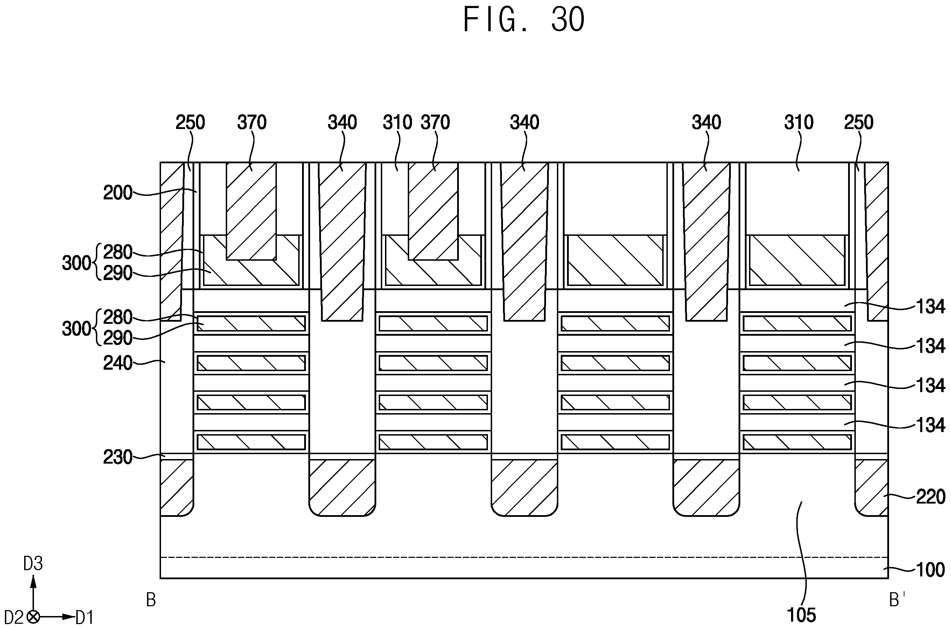

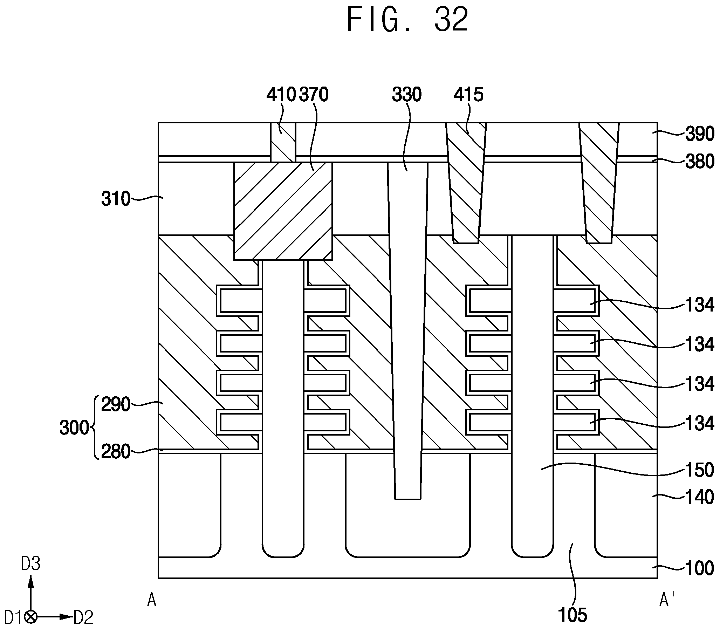

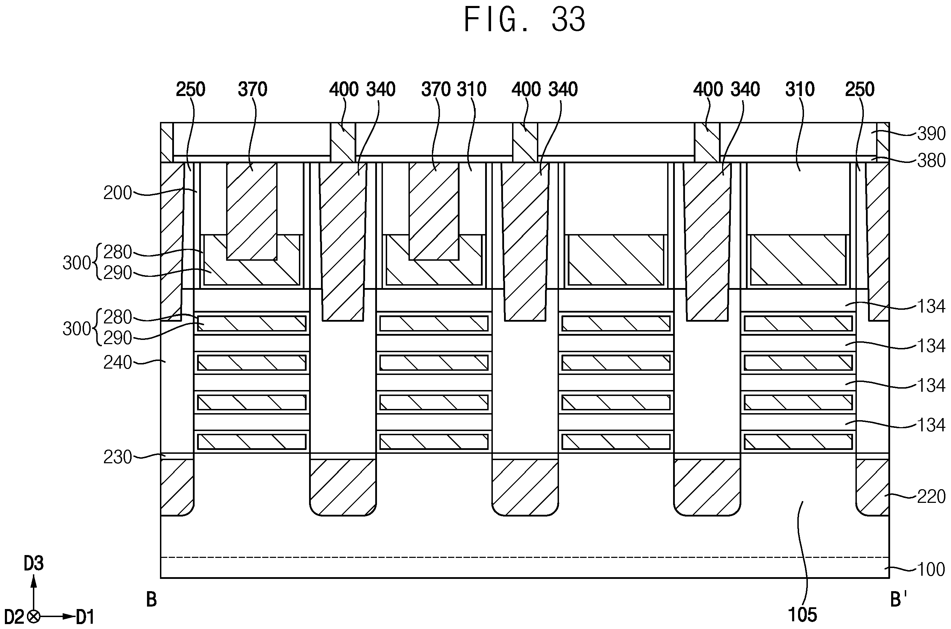

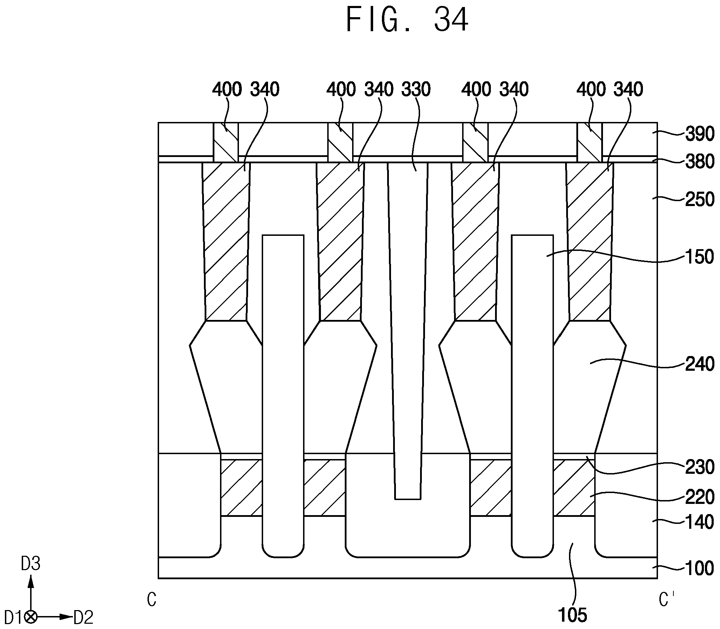

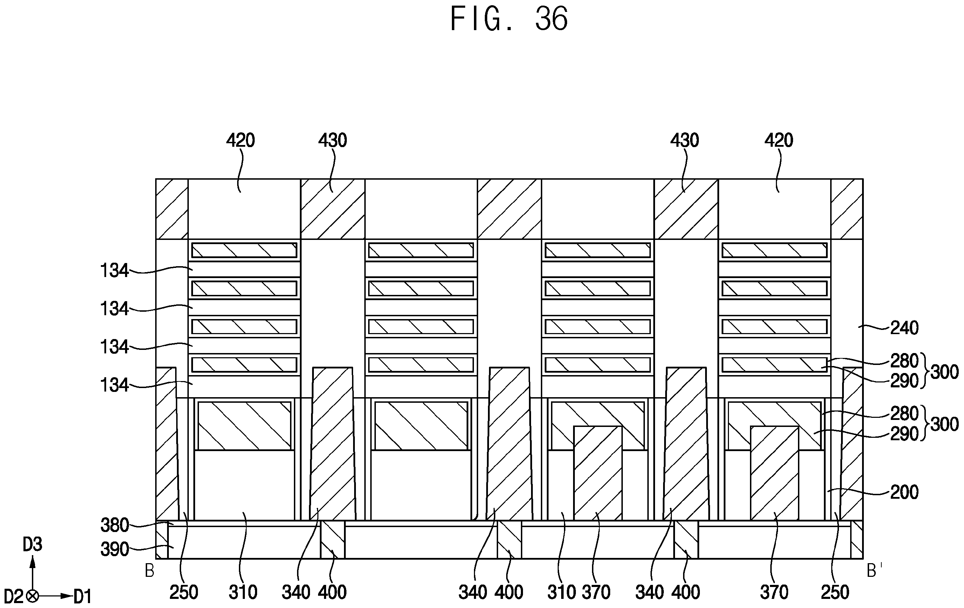

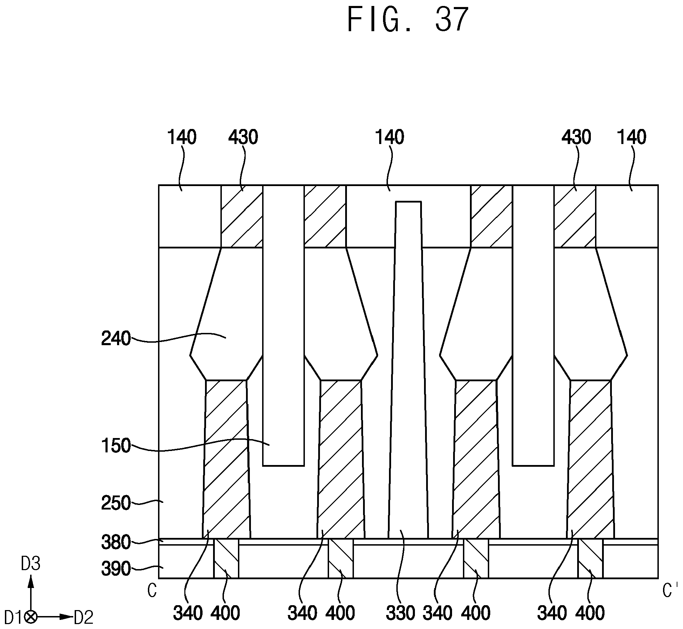

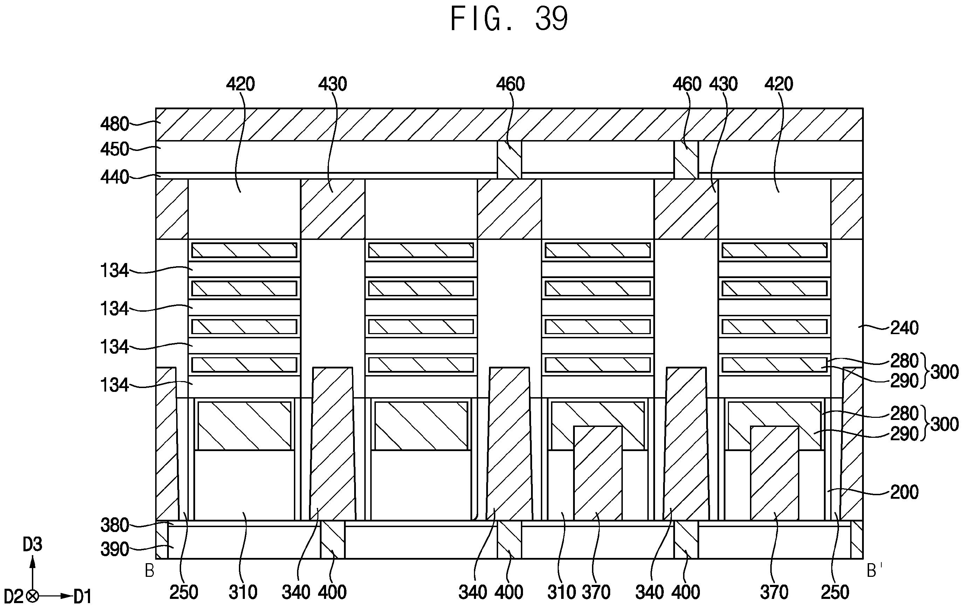

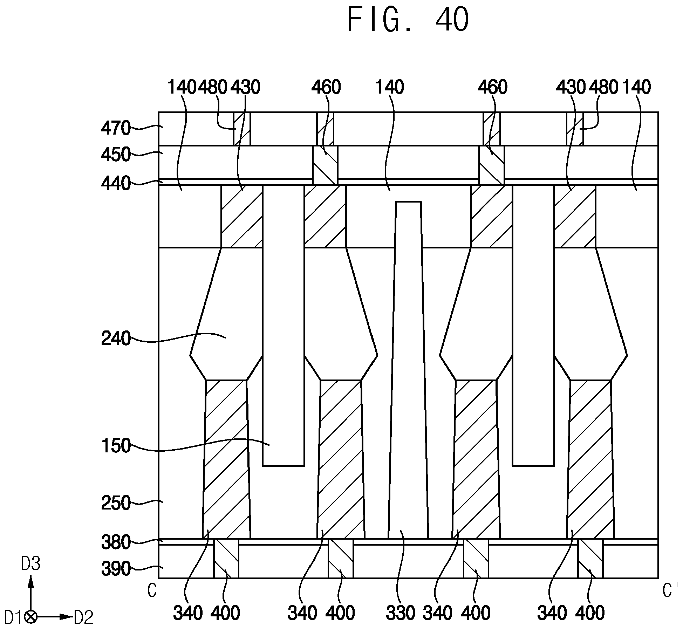

FIGS. 5 to 40 are plan views and cross-sectional views illustrating a method of manufacturing a semiconductor device in accordance with example embodiments. Particularly, FIGS. 5, 7, 10, 14, 18, 21, 25, 28 and 31 are the plan views, and FIGS. 6, 8-9, 11-13, 15-17, 19-20, 22-24, 26-27, 29-30 and 32-40 are the cross-sectional views.

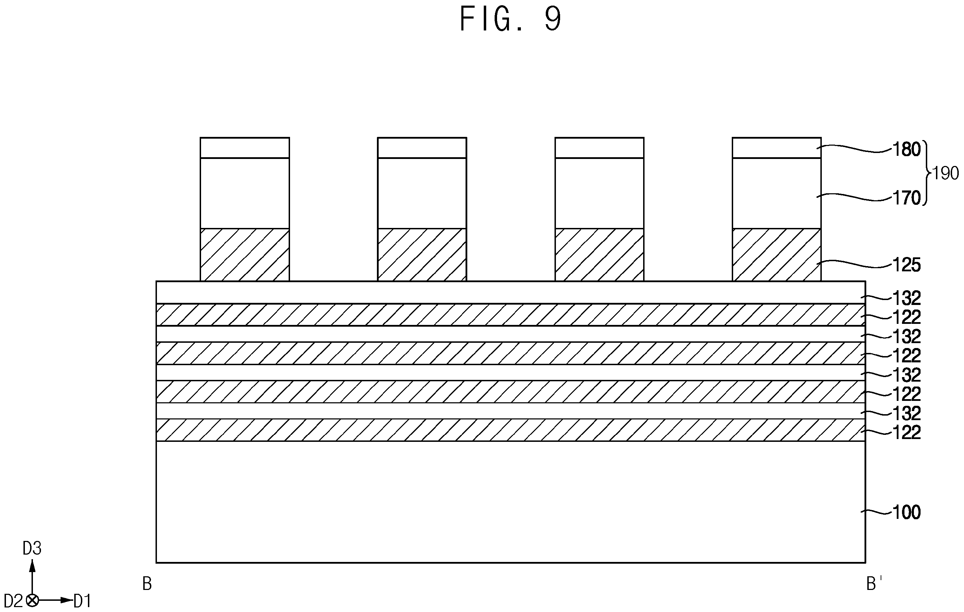

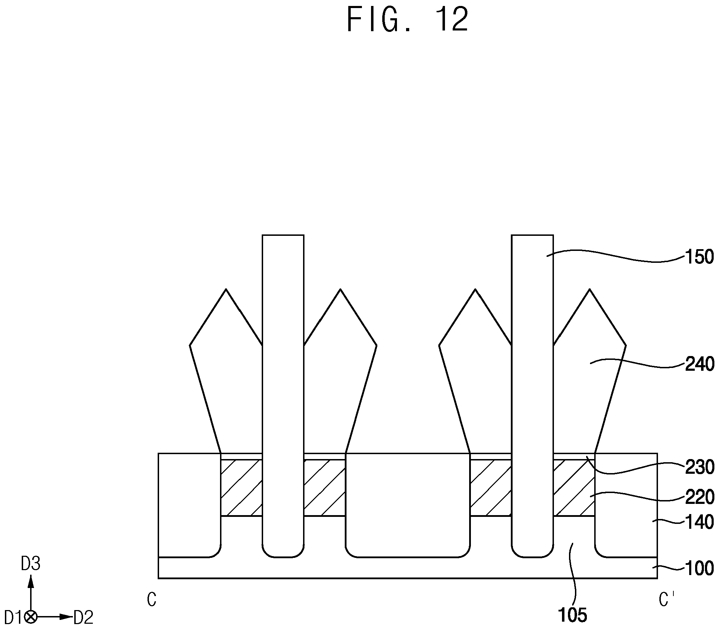

FIGS. 6, 8, 15, 19, 22, 26, 29, 32, 35 and 38 are cross-sectional views taken along lines A-A' of corresponding plan views, respectively; FIGS. 9, 11, 13, 16, 23, 27, 30, 33, 36 and 39 are cross-sectional views taken along lines B-B' of corresponding plan views, respectively; and FIGS. 12, 17, 20, 24, 34, 37 and 40 are cross-sectional views taken along lines C-C' of corresponding plan views, respectively.

Referring to FIGS. 5 and 6, a first sacrificial layer and a semiconductor layer may be alternately and repeatedly stacked on a substrate 100 in the third direction D3, a second sacrificial layer may be formed on an uppermost one of the semiconductor layers, and the second sacrificial layer, the semiconductor layers, the first sacrificial layers and an upper portion of the substrate 100 may be etched by an etching process.

In an example embodiment, the first and second sacrificial layers and the semiconductor layer may be formed by a selective epitaxial growth (SEG) process using an upper portion of the substrate 100 as a seed. In some example embodiments, the first and second sacrificial layers and the semiconductor layer may be formed by a deposition process, e.g., a chemical vapor deposition (CVD) process, an atomic layer deposition (ALD) process, etc.

In some embodiments, a first insulation layer including an oxide, e.g., silicon oxide may be further formed between the uppermost one of the semiconductor layers and the second sacrificial layer.

By the etching process, a first trench 112 may be formed on the substrate 100 to have a first width w1 in the second direction D2, and an active pattern 105 may be defined by the first trench 112 on the substrate 100. In example embodiments, the active pattern 105 may extend in the first direction D1, and a plurality of active patterns 105 may be spaced apart from each other in the second direction D2.

A stack structure including first sacrificial lines 122 and semiconductor lines 132 alternately and repeatedly stacked in the third direction D3 and a second sacrificial line 123 may be formed on each of the active pattern 105. As described above, if the first insulation layer is formed between the uppermost one of the semiconductor layers and the second sacrificial layer, a first insulation pattern may be formed between an uppermost one of the semiconductor lines 132 and the second sacrificial line 123.

An isolation layer may be formed on the substrate 100 having the active pattern 105, the stack structure and the second sacrificial line 123 thereon to fill the first trench 112, and an upper portion of the isolation layer may be removed by, e.g., an etch back process to form an isolation pattern 140 in the first trench 112.

An etching process may be further performed on the stack structure, the second sacrificial line 123 and the active pattern 105, each of which may extend in the first direction D1. Thus, each of the stack structure, the second sacrificial line 123 and the active pattern 105 may be divided in the second direction D2, and a second trench 114 having a second width w2 in the second direction D2 smaller than the first width w1 may be formed on the substrate 100.

A distance between stack structures at opposite sides, respectively, in the second direction D2 of the second trench 114 may be smaller than a distance between stack structures at opposite sides, respectively, in the second direction D2 of the first trench 112.

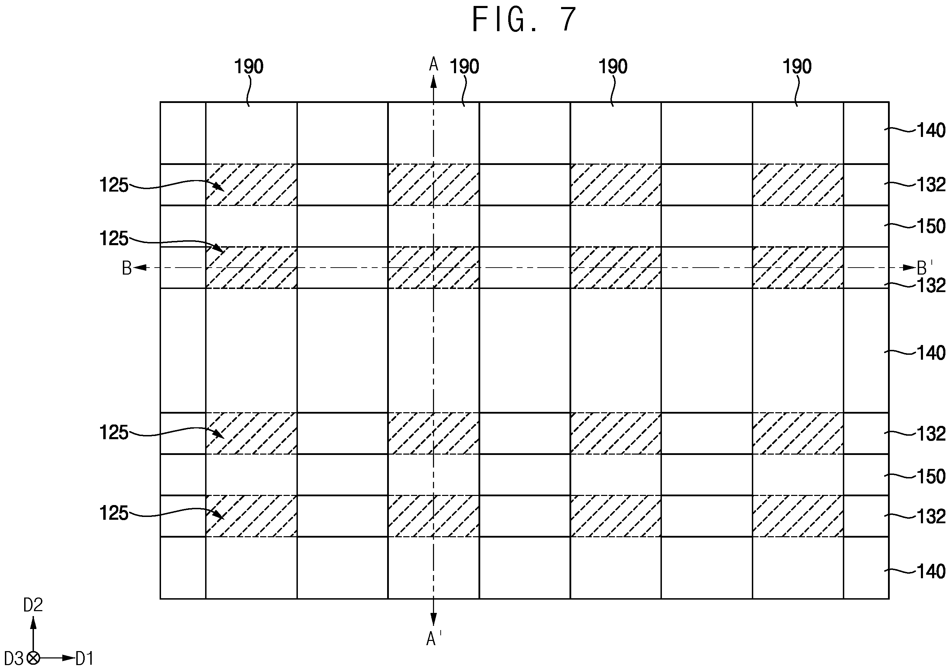

Referring to FIGS. 7 to 9, a first division layer may be formed by a deposition process on the substrate 100 having the stack structure, the second sacrificial line 123, the active pattern 105 and the isolation pattern 140 thereon, and, for example, a wet etching process may be performed on the first division layer.

As the wet etching process is performed, the first division layer may remain as a first division pattern 150 in the second trench 114, in a space between first ones of the stack structures that are spaced apart from each other by a relatively small distance and in a space between first ones of the second sacrificial lines 123 on the first ones of the stack structures, respectively, and the first division layer may be removed from a space between second ones of the stack structures that are spaced apart from each other by a relatively large distance and in a space between second ones of the second sacrificial lines 123 on the second ones of the stack structures, respectively.

In example embodiments, the first division pattern 150 may extend in the first direction D1, and a plurality of first division patterns 150 may be spaced apart from each other in the second direction D2. An upper surface of the first division pattern 150 may be substantially coplanar with an upper surface of the second sacrificial line 123.

A dummy gate electrode layer and a dummy gate mask layer may be sequentially formed on the substrate 100 having the stack structure, the second sacrificial line 123, the first division pattern 150 and the isolation pattern 140 thereon, the dummy gate mask layer may be etched to form a dummy gate mask 180, and the dummy gate electrode layer and the second sacrificial line 123 may be etched using the dummy gate mask 180 as an etching mask to form a dummy gate electrode 170 and a second sacrificial pattern 125, respectively.

The dummy gate electrode 170 and the dummy gate mask 180 may collectively form a dummy gate structure 190. In example embodiments, the dummy gate structure 190 may extend in the second direction D2, and a plurality of dummy gate structures 190 may be spaced apart from each other in the first direction D1. The dummy gate electrode 170 may include, e.g., polysilicon, and the dummy gate mask 180 may include an insulating nitride, e.g., silicon nitride.

As the etching process is performed, the second sacrificial line 123 extending in the first direction D1 may be divided into second sacrificial patterns 125 spaced apart from each other in the first direction D 1.

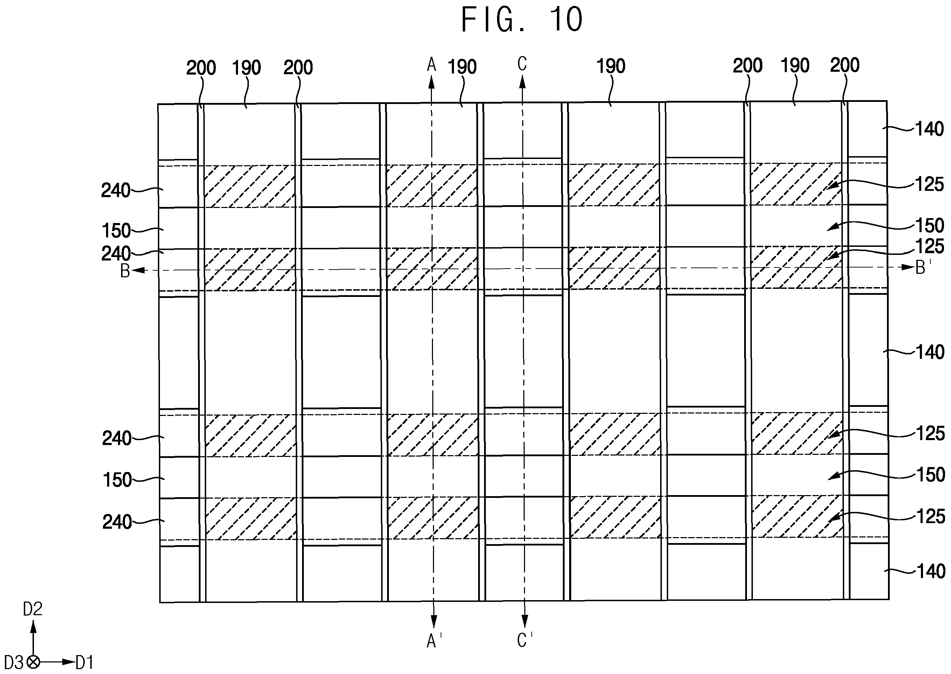

Referring to FIGS. 10 to 12, a spacer layer may be formed on the substrate 100 having dummy gate structure 190, the second sacrificial pattern 125, the stack structure, the first division pattern 150 and the isolation pattern 140, and may be anisotropically etched to form a gate spacer 200 on each of opposite sidewalls in the first direction D1 of the dummy gate structure 190 and the second sacrificial pattern 125.

The stack structure and an upper portion of the active pattern 105 may be etched using the dummy gate structure 190, the second sacrificial pattern 125 and the gate spacer 200 as an etching mask.

Thus, the first sacrificial line 122 and the semiconductor line 132 each of which may extend in the first direction D1 may be divided into first sacrificial patterns 124 and semiconductor patterns 134, respectively, and the stack structure extending in the first direction D1 may be divided into a plurality of parts spaced apart from each other in the first direction D 1. By the etching process, a third trench 116 may be formed on the active pattern 105.

In an example embodiment, a bottom of the third trench 116 may be higher than bottoms of the first and second trenches 112 and 114. For example, a distance from a bottom of the substrate 100 to the bottom of the third trench 116 may be greater than a distance from the bottom of the substrate 100 to bottoms of each of the first and second trenches 112 and 114.

A third sacrificial pattern 220 may be formed in the third trench 116. The third sacrificial pattern 220 may be formed by a SEG process using an upper surface of the active pattern 105 exposed by the third trench 116, and may include, e.g., silicon-germanium (SiGe). In an example embodiment, an upper surface of the third sacrificial pattern 220 may be lower than a top end of the third trench 116.

A first etch stop pattern 230 may be formed on the third sacrificial pattern 220. The first etch stop pattern 230 may include an insulating nitride, e.g., silicon nitride. In an example embodiment, an upper surface of the first etch stop pattern 230 may be substantially coplanar with the top end of the third trench 116. However, example embodiments are not limited thereto.

A source/drain layer 240 may be formed on the first etch stop pattern 230.

In example embodiments, the source/drain layer 240 may be formed by a SEG process using sidewalls of the first sacrificial patterns 124 and the semiconductor patterns 134 as a seed.

In example embodiments, the SEG process may be performed using a silicon source gas, e.g., dichlorosilane (SiH₂Cl₂) gas, a germanium source gas, e.g., germane (GeH₄) gas, and thus a single crystalline silicon-germanium layer may be formed. P-type impurities may be doped into the single crystalline silicon-germanium layer and a heat treatment process may be performed to form the source/drain layer 240, which may serve as a source/drain of a PMOS transistor.

In some example embodiments, the SEG process may be performed using a silicon source gas, e.g., disilane (Si₂H₆) gas to form a single crystalline silicon layer, or may be performed using a carbon source gas, e.g., SiH₃CH₃ together with the silicon source gas to form a single crystalline silicon carbide layer. N-type impurities may be doped into the single crystalline silicon layer or the single crystalline silicon carbide layer and a heat treatment process may be performed to form the source/drain layer 240, which may serve as a source/drain of an NMOS transistor.

In example embodiments, the source/drain layer 240 may be formed at each of opposite sides in the first direction D1 of the stack structure, and may contact sidewalls in the first direction D1 of the first sacrificial patterns 124 and the semiconductor patterns 134 and a sidewall in the second direction D2 of the first division pattern 150.

In an example embodiment, a cross-section in the second direction D2 of the source/drain layer 240 may have a shape of, e.g., a pentagon as illustrated in FIG. 12. However, example embodiments are not limited thereto. For example, the cross-section in the second direction D2 of the source/drain layer 240 may have a shape of, e.g., a rectangle with rounded corners.

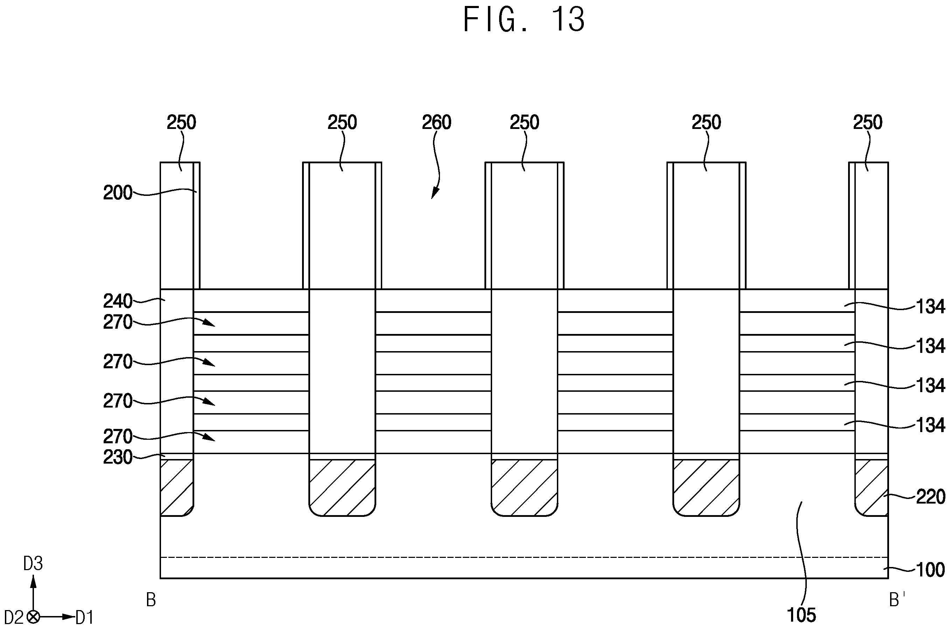

Referring to FIG. 13, a first insulating interlayer may be formed on the substrate 100 to cover the dummy gate structure 190, the second sacrificial pattern 125, the gate spacer 200, the stack structure, the first division pattern 150, the source/drain layer 240 and the isolation pattern 140, and a planarization process may be performed on the first insulating interlayer until an upper surface of the dummy gate electrode 170 of the dummy gate structure 190 is exposed to form a first insulating interlayer pattern 250.

The planarization process may include a chemical mechanical polishing (CMP) process and/or an etch back process.

During the planarization process, the dummy gate mask 180 of the dummy gate structure 190 and an upper portion of the gate spacer 200 may also be removed.

The dummy gate electrode 170 and the second sacrificial pattern 125 may be removed to form a first opening 260, and the first sacrificial patterns 124 may be removed to form a second opening 270 exposing surfaces of the semiconductor patterns 134 and an upper surface of the active pattern 105.

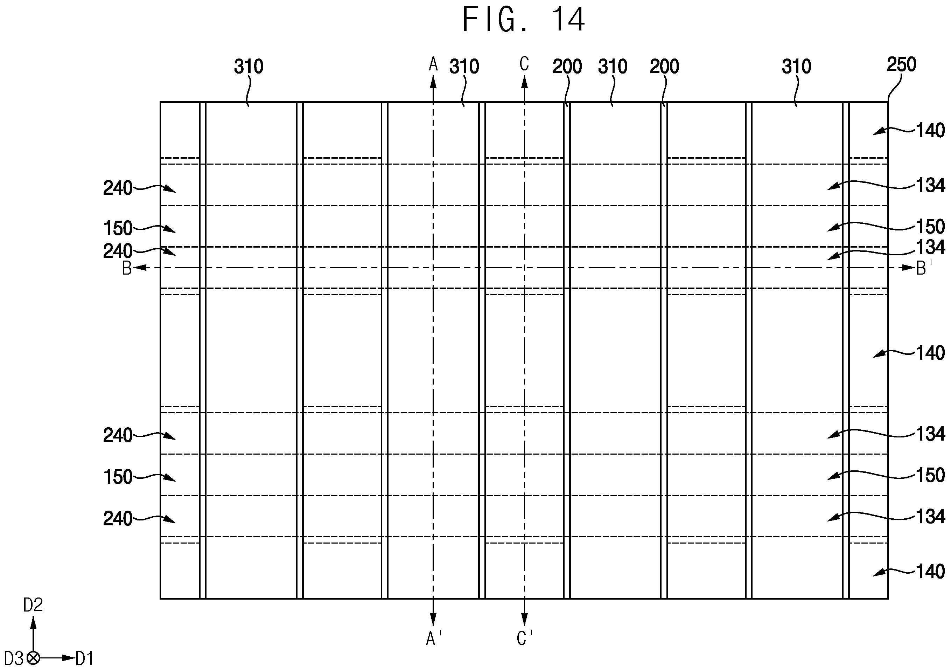

Referring to FIGS. 14 to 17, a gate structure 300 may be formed in the first and second openings 260 and 270.

Particularly, a thermal oxidation process may be performed on the upper surface of the active pattern 105 and the surface of the semiconductor pattern 134 exposed by the first and second openings 260 and 270 to form an interface pattern, a gate insulation layer may be conformally formed on a surface of the interface pattern, an inner sidewall of the gate spacer 200 and an upper surface of the first insulating interlayer pattern 250, and a gate electrode layer may be formed on the gate insulation layer to fill the first and second openings 260 and 270.

The gate insulation layer and the gate electrode layer may be formed by, e.g., a CVD process, an ALD process or a physical vapor deposition (PVD) process.

The gate electrode layer and the gate insulation layer may be planarized until the upper surface of the first insulating interlayer pattern 250 is exposed to form a gate electrode 290 and a gate insulation pattern 280, respectively, which may collectively form the gate structure 300.

An upper portion of the gate structure 300 may be removed to form a recess, and a capping pattern 310 may be formed in the recess. In example embodiments, the recess may expose an upper surface of the first division pattern 150, and thus portions of the gate electrode 290 at opposite sides, respectively, in the second direction D2 of the first division pattern 150 may be separated from each other.

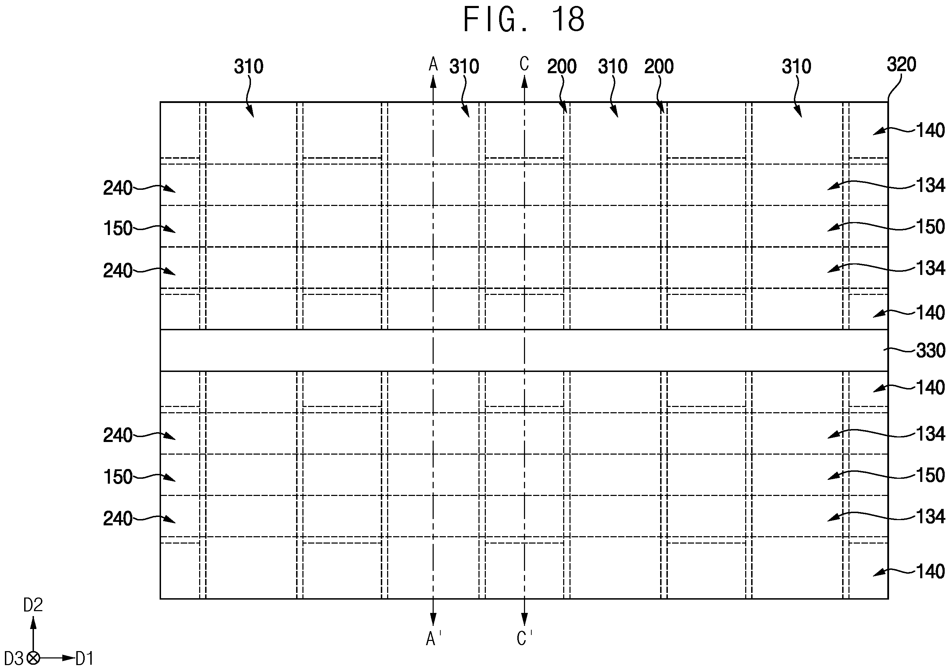

Referring to FIGS. 18 to 20, a second insulating interlayer 320 may be formed on the capping pattern 310, the gate spacer 200 and the first insulating interlayer pattern 250. A second division pattern 330 may be formed through the second insulating interlayer 320, the capping pattern 310, the gate structure 300 and an upper portion of the isolation pattern 140.

The second insulating interlayer 320 may include an oxide, e.g., silicon oxide.

In example embodiments, the second division pattern 330 may extend in the first direction D 1, and thus may also extend through the first insulating interlayer pattern 250.

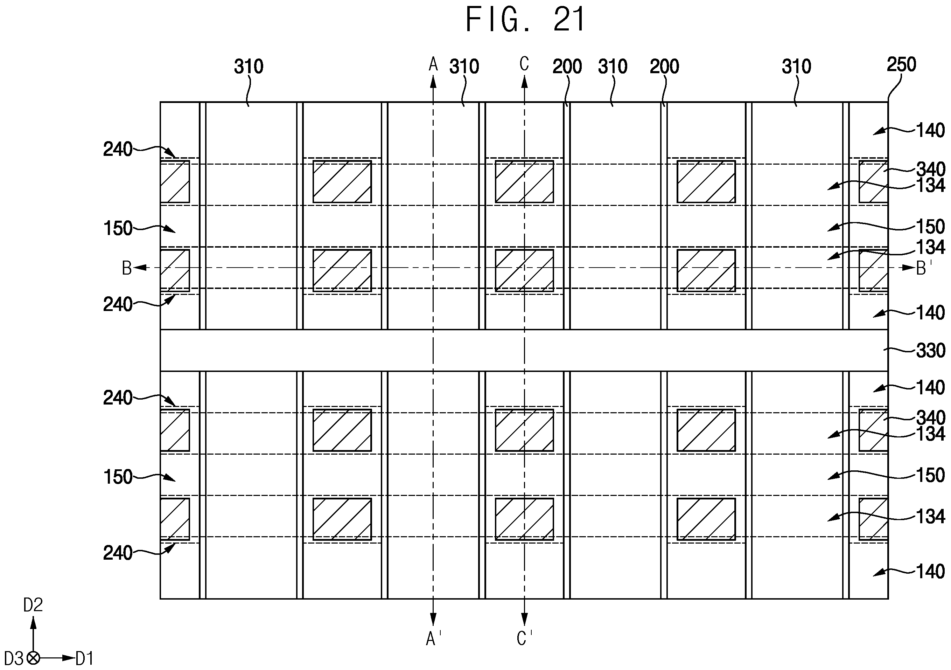

Referring to FIGS. 21 to 24, the second insulating interlayer 320 and an upper portion of the second division pattern 330 may be removed to expose upper surfaces of the capping pattern 310, the gate spacer 200 and the first insulating interlayer pattern 250. A third opening may be formed through an upper portion of the first insulating interlayer pattern 250 to expose an upper surface of the source/drain layer 240, and a first contact plug 340 may be formed in the third opening.

In example embodiments, a plurality of first contact plugs 340 may be spaced apart from each other in the first and second directions D1 and D2.

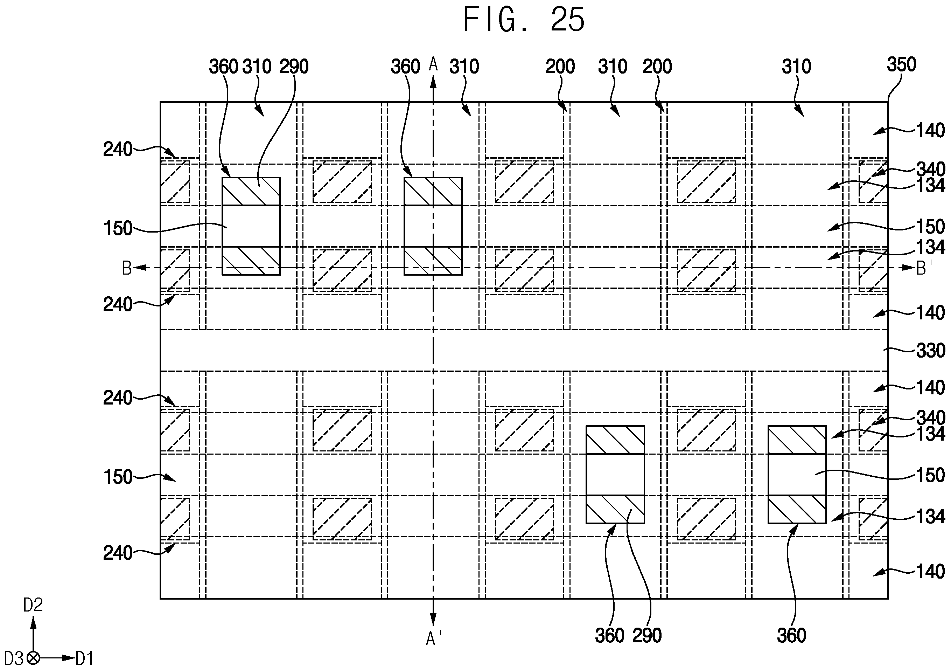

Referring to FIGS. 25 to 27, a third insulating interlayer 350 may be formed on the capping pattern 310, the gate spacer 200, the first insulating interlayer pattern 250 and the first contact plug 340. A fourth opening 360 may be formed through the third insulating interlayer 350, the capping pattern 310, and upper portion of the gate electrode 290 of the gate structure 300 and an upper portion of the first division pattern 150.

The third insulating interlayer 350 may include an oxide, e.g., silicon oxide.

In example embodiments, the fourth opening 360 may extend through upper portions of the gate electrodes 290 at opposite sides, respectively, in the second direction D2 of the first division pattern 150.

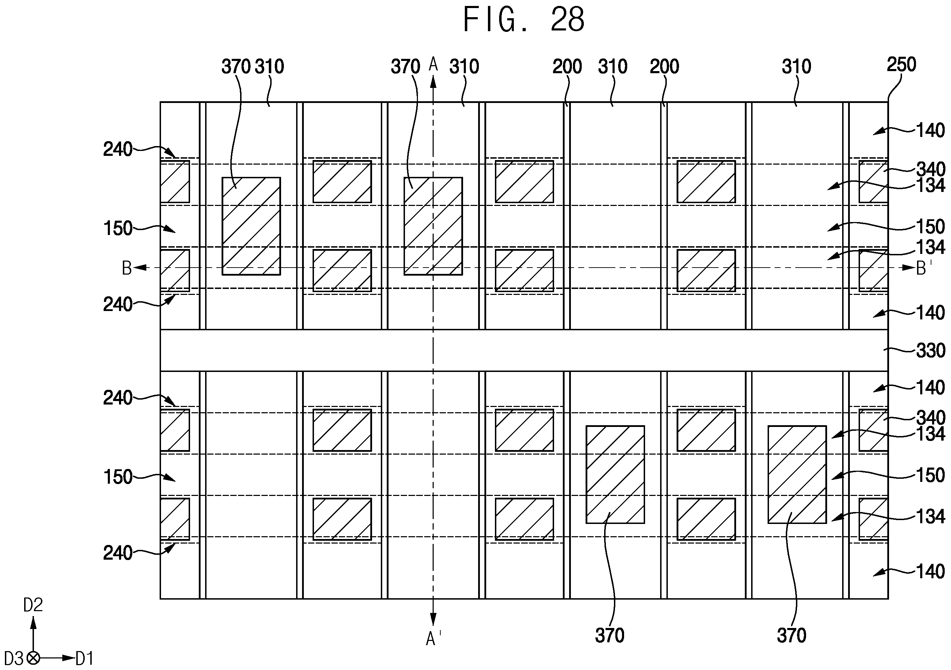

Referring to FIGS. 28 to 30, a connection layer may be formed on the gate electrode layer 290 and the third insulating interlayer 350 to fill the fourth opening 360, and a planarization process may be performed on the third insulating interlayer 350.

During the planarization process, an upper portion of the connection layer may also be removed to form a connection pattern 370, which may commonly contact upper sidewalls of the gate electrodes 290 at opposite sides, respectively, in the second direction D2 of the first division pattern 150.

In example embodiments, a plurality of connection patterns 370 may be spaced apart from each other in the first and second directions D1 and D2.

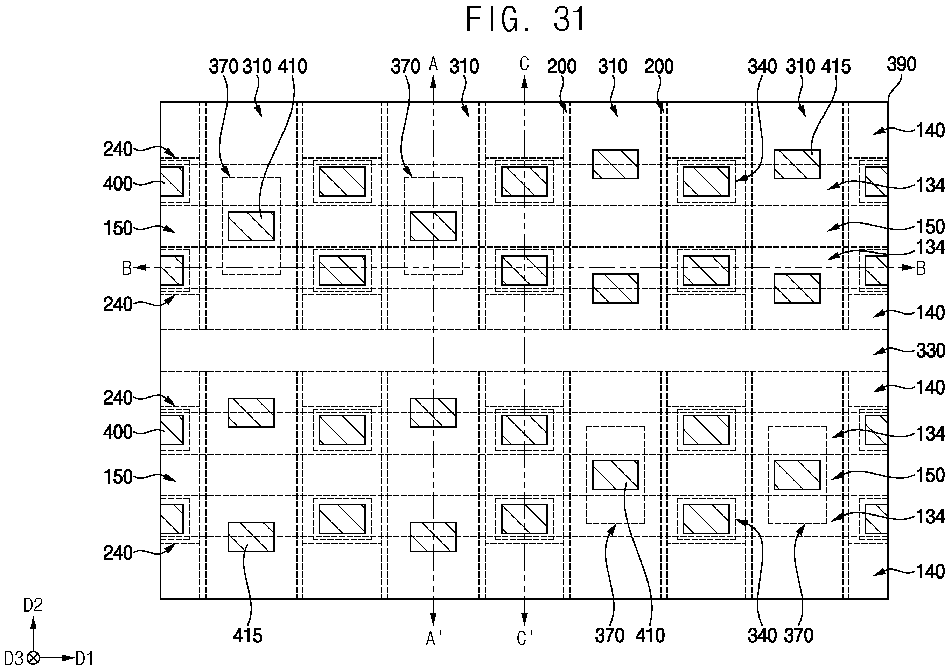

Referring to FIGS. 31 to 34, a second etch stop layer 380 and a fourth insulating interlayer 390 may be sequentially formed on the capping pattern 310, the gate spacer 200, the first insulating interlayer pattern 250, the first contact plug 340 and the connection pattern 370.

First vias 400 extending through the second etch stop layer 380 and the fourth insulating interlayer 390 to contact upper surfaces of the first contact plugs 340 may be formed, and second vias 400 extending through the second etch stop layer 380 and the fourth insulating interlayer 390 to contact upper surfaces of the connection patterns 370 may be formed. A second contact plug 415 extending through the capping pattern 310, the second etch stop layer 380 and the fourth insulating interlayer 390 to contact an upper surface of the gate electrode 290 may be formed.

An upper wiring may be further formed to contact the first and second vias 400 and 410 and the second contact plug 415.

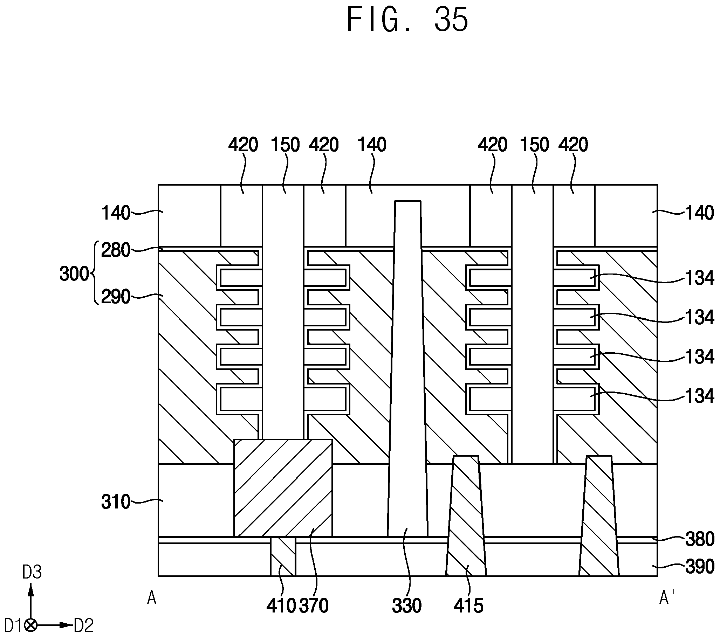

Referring to FIGS. 35 to 37, after overturning the substrate 100, the substrate 100 and upper portions of the active pattern 105, the isolation pattern 140 and the first division pattern 150 may be removed by, e.g., a grinding process and/or a CMP process until the third sacrificial pattern 220 is exposed.

A remaining portion of the active pattern 105 may be removed by, e.g., a wet etching process to form a fifth opening exposing an upper surface of the gate structure 300, and a second insulation pattern 420 may be formed in the fifth opening. In an example embodiment, the second insulation pattern 420 may include a material substantially the same as a material of the isolation pattern 140, and thus, in some embodiments, may be merged with the isolation pattern 140.

The third sacrificial pattern 220 and the first etch stop pattern 230 may be removed to form a sixth opening exposing an upper surface of the source/drain layer 240. A third contact plug 430 may be formed in the sixth opening.

In example embodiments, a plurality of third contact plugs 430 may be spaced apart from each other in the first and second directions D1 and D2.

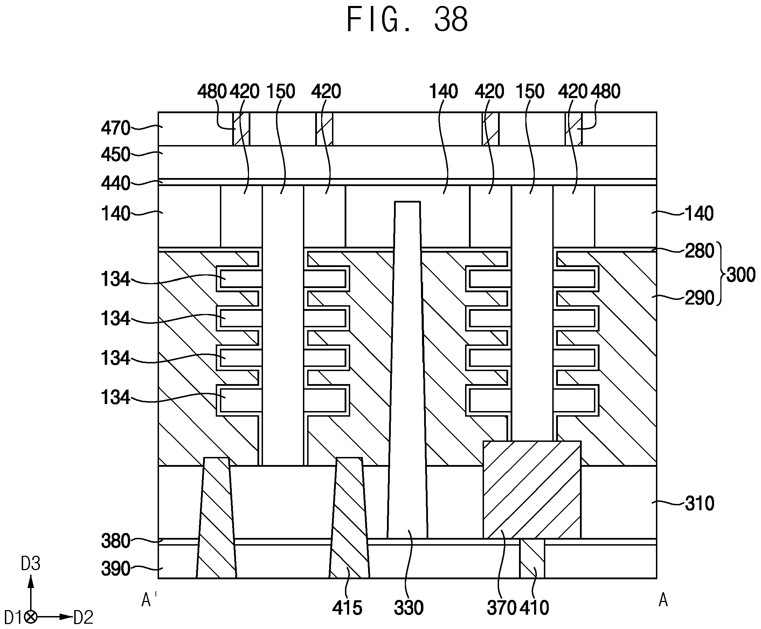

Referring to FIGS. 38 to 40, a third etch stop layer 440 and a fifth insulating interlayer 450 may be sequentially formed on the second insulation pattern 420, the third contact plug 430, the first division pattern 150 and the isolation pattern 140. A third via 460 may be formed through the third etch stop layer 440 and the fifth insulating interlayer 450 to contact an upper surface of the third contact plug 430.

In example embodiments, a plurality of third vias 460 may be spaced apart from each other in the first and second directions D1 and D2.

A sixth insulating interlayer 470 may be formed on the fifth insulating interlayer 450 and the third via 460. A first wiring 480 may be formed to contact an upper surface of the third via 460.

The above structures may be overturned again so that the semiconductor devices shown in FIGS. 1 to 4 may be manufactured.

As illustrated above, the first and second division patterns 150 and 330 may be formed to divide the gate structure 300 in the second direction D2, and the connection pattern 370 commonly contacting the upper portions of the gate structures 300, which may be divided by the first division pattern 150 and disposed at opposite sides, respectively, in the second direction D2 of the first division pattern 150, may be formed so that the gate structures 300 may be electrically connected to each other.

The connection pattern 370 may not have a linear shape extending in the second direction D2 and commonly contacting the upper surfaces of the gate structures 300, but may extend only through portions of the gate structures 300 adjacent to the first division pattern 150 in the second direction D2. The upper surfaces of the gate structures 300 may be lower than the upper surface of the first contact plug 340 on the source/drain layer 240, and the upper surface of the connection pattern 370 may be substantially coplanar with the upper surface of the first contact plug 340.

Thus, when compared to a related art case in which a connection pattern having a linear shape is disposed on an entire portion of the gate structures 300 to overlap the first contact plug 340 in the horizontal direction, the connection pattern 370 according to various example embodiments may partially contact the upper surfaces of the gate structure 300 to have a relatively small length in the second direction D2 as compared to the related art case. Accordingly, a parasitic capacitance between the connection pattern 370 and the first contact plug 340 may decrease. Furthermore, as described above, an opening 360 is formed through an upper portion of the gate structure and a connection layer is formed to fill the opening. As such, it is not required that a difficult etching process be performed on a conductive layer provided on top of the gate structure, in which large amounts of conductive layer are etched away to form the connection pattern, as in a related art case. Therefore the manufacturing process of the semiconductor device may be simplified.

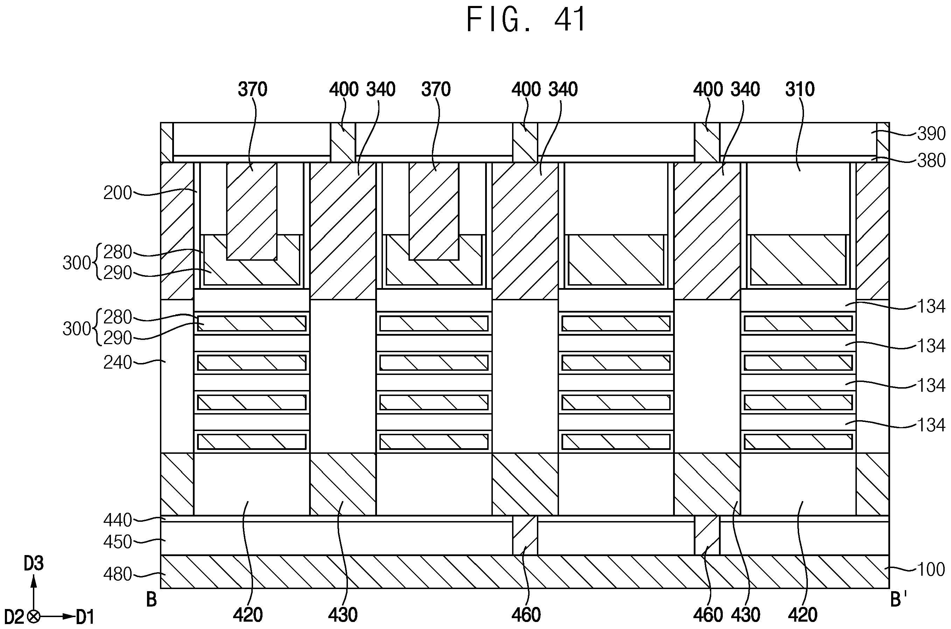

FIG. 41 is a cross-sectional view illustrating a semiconductor device in accordance with example embodiments, and may correspond to FIG. 3. The semiconductor device illustrated in FIG. 41 may be substantially the same as or similar to that of FIGS. 1 to 4, except for some elements, and thus repeated explanations are omitted herein for conciseness.

Referring to FIG. 41, in some example embodiments, the first contact plug 340 may contact an outer sidewall of the gate spacer 200.

That is, when the third opening is formed by the processes illustrated with reference to FIGS. 21 to 24, the third opening may extend through the first insulating interlayer pattern 250 to expose the upper surface of the source/drain layer 240, and may also expose an outer sidewall of the gate spacer 200 covered by the first insulating interlayer pattern 250. Thus, the first contact plug 340 that may be formed in the third opening may contact the gate spacer 200, and may be formed to be self-aligned with the gate spacer 200.

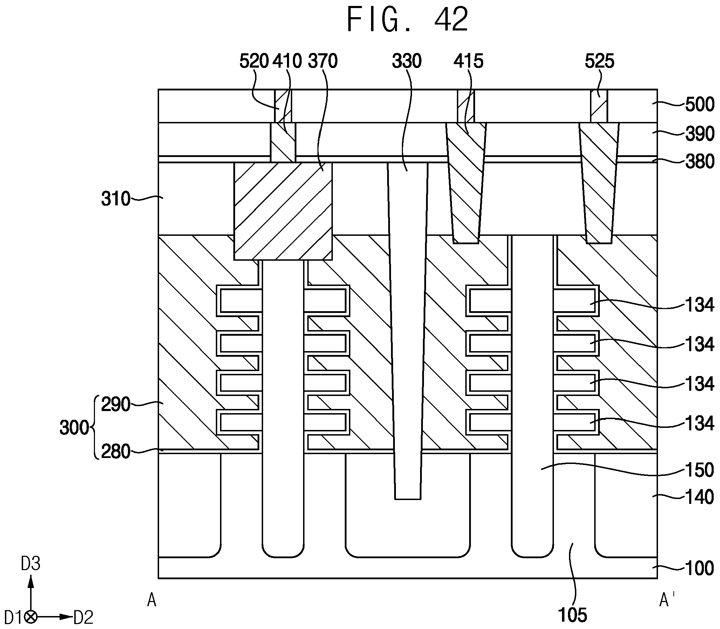

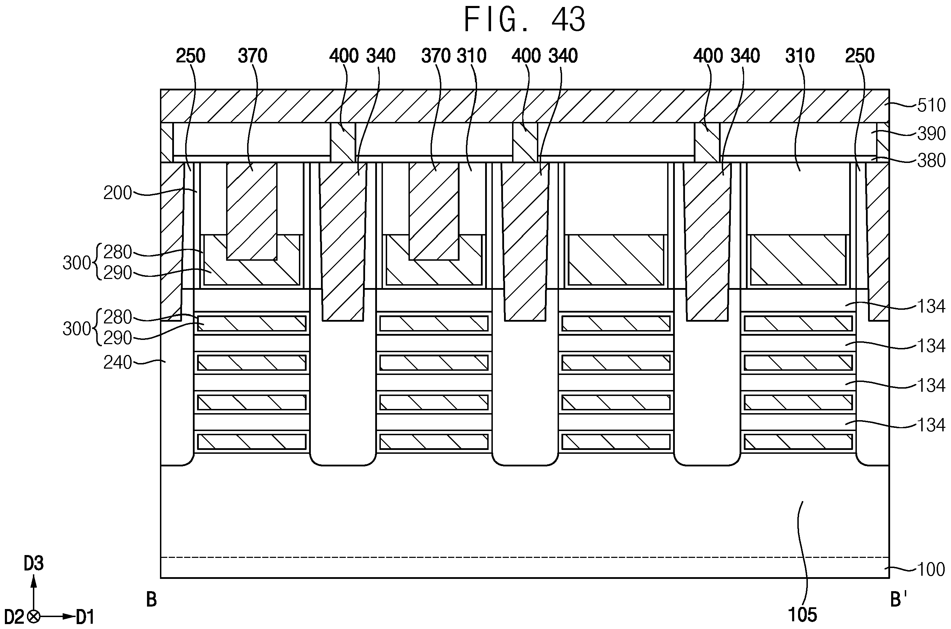

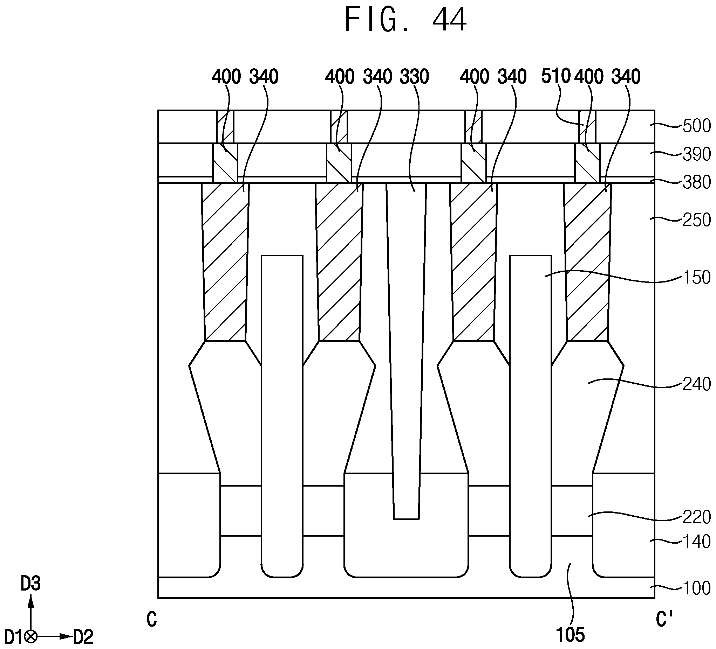

FIGS. 42 to 44 are cross-sectional views illustrating a semiconductor device in accordance with example embodiments, and may correspond to FIGS. 2 to 4, respectively. The semiconductor device illustrated in FIGS. 42-44 may be substantially the same as or similar to that of FIGS. 1 to 4, except for some elements, and thus repeated explanations are omitted herein for conciseness.

Referring to FIGS. 42 to 44, the semiconductor device according to some example embodiments may be formed by performing the processes substantially the same as or similar to those illustrated with reference to illustrated with reference to FIGS. 5 to 34, and forming a seventh insulating interlayer 500 and a second wiring 510, a third wiring 520, and a fourth wiring 525 on the fourth insulating interlayer 390, the first vias 400 and second vias and the second contact plug 415, without performing the processes for forming the third contact plug 430, the third via 460 and the first wiring 480 on a backside of the substrate 100.

That is, the semiconductor device illustrated in FIGS. 42-44 may include the first wiring 480 serving as a signal line or a power rail not on the backside but on a frontside of the substrate 100.

Thus, the semiconductor device illustrated in FIGS. 42-44 may omit the second insulation pattern 420, the third contact plug 430, the fifth and sixth insulating interlayers 450 and 470, the third etch stop layer 440, the third via 460 and the first wiring 480. In this case, the substrate 100 and the active pattern 105 may not be removed from the semiconductor device.

Accordingly, the gate structure 300 may be formed on the active pattern 105 and the isolation pattern 140 on the substrate 100, the first division pattern 150 may extend through the active pattern 105 to contact the substrate 100, and the source/drain layer 240 may be formed on the upper surface of the active pattern 105 adjacent to the gate structure 300 in the first direction D1.

The substrate 100 may include a semiconductor material, e.g., silicon, germanium, silicon-germanium, etc., or a III-V group compound semiconductor, e.g., GaP, GaAs, GaSb, etc. In example embodiments, the substrate 100 may be a silicon-on-insulator (SOI) substrate or a germanium-on-insulator (GOI) substrate.

The active pattern 105 may protrude from an upper surface of the substrate 100 in the third direction D3, and may also be referred to as an active fin. In example embodiments, the active pattern 105 may extend in the first direction D1, and a plurality of active patterns 105 may be spaced apart from each other in the second direction D2. The active pattern 105 may be defined by removing an upper portion of the substrate 100, and thus may include substantially the same material as the substrate 100.

The seventh insulating interlayer 500 may include an oxide, e.g., silicon oxide or a low-k dielectric material.

The second to fourth wirings 510, 520 and 525 may contact upper surfaces of the first via 400, the second via 410 and the second contact plug 415, respectively. In an example embodiment, each of the second to fourth wirings 510, 520 and 525 may extend in the first direction D 1. A plurality of second wirings 510 may be spaced apart from each other in the second direction D2, a plurality of third wirings 520 may be spaced apart from each other in the second direction D2, and a plurality of fourth wirings 525 may be spaced apart from each other in the second direction D2. Each of the second to fourth wirings 510, 520 and 525 may serve as a signal line or a power rail. Each of the second to fourth wirings 510, 520 and 525 may include a conductive material, e.g., a metal, a metal nitride, a metal silicide, etc.

The foregoing is illustrative of example embodiments and is not to be construed as limiting thereof. Although a few example embodiments have been described, those skilled in the art will readily appreciate that many modifications are possible in the example embodiments without materially departing from the novel teachings and advantages of the present disclosure. Accordingly, all such modifications are intended to be included within the scope of the present disclosure as defined in the claims. In the claims, means-plus-function clauses are intended to cover the structures described herein as performing the recited function and not only structural equivalents but also equivalent structures. Therefore, it is to be understood that the foregoing is illustrative of various example embodiments and is not to be construed as limited to the specific example embodiments disclosed, and that modifications to the disclosed example embodiments, as well as other example embodiments, are intended to be included within the scope of the appended claims.

## Claims

1. A semiconductor device comprising:
gate structures on an insulation structure, the gate structures being disposed in a second direction substantially parallel to an upper surface of the insulation structure;
source/drain layers at opposite sides, respectively, of each of the gate structures in a first direction substantially parallel to the upper surface of the insulation structure and intersecting the second direction;
semiconductor patterns disposed in a third direction substantially perpendicular to the upper surface of the insulation structure, the semiconductor patterns extending through each of the gate structures and contacting the source/drain layers;
a first division pattern between the gate structures; and
a connection pattern extending into and contacting an upper portion of the first division pattern and upper portions of the gate structures adjacent to the upper portion of the first division pattern, a lower surface of the connection pattern being lower than upper surfaces of the gate structures and an upper surface of the connection pattern being higher than the upper surfaces of the gate structures.

2. The semiconductor device as claimed in claim 1, further comprising a contact plug on each of the source/drain layers,
wherein the upper surface of the connection pattern is substantially coplanar with an upper surface of the contact plug.

3. The semiconductor device as claimed in claim 1 or claim 2, further comprising a capping pattern on the gate structures,
wherein the connection pattern extends through the capping pattern.

4. The semiconductor device as claimed in any preceding claim, wherein each of the gate structures includes a gate insulation pattern and a gate electrode, and
wherein the gate insulation pattern extends in the third direction, and
wherein the gate insulation pattern covers an upper surface and a lower surface of each of the semiconductor patterns, a sidewall in the second direction of each of the semiconductor patterns and a sidewall of a portion of the first division pattern between the semiconductor patterns.

5. The semiconductor device as claimed in any one of claims 1 - 3, further comprising a second division pattern between the gate structures,
wherein the second division pattern extends into an upper portion of the insulation structure.

6. The semiconductor device as claimed in claim 5, wherein an upper surface of the second division pattern is substantially coplanar with the upper surface of the connection pattern.

7. The semiconductor device as claimed in claim 5 or claim 6, wherein each of the gate structures includes a gate insulation pattern and a gate electrode, and
wherein the gate electrode contacts a sidewall of the second division pattern.

8. The semiconductor device as claimed in claim 4 or claim 7, wherein the gate insulation pattern contacts the lower surface of the connection pattern.

9. The semiconductor device as claimed in any preceding claim, wherein each of the gate structures includes a lower portion and an upper portion sequentially stacked, the upper portion being disposed on an uppermost one of the semiconductor patterns, and
wherein a width in the first direction of the upper portion of each of the gate structures is smaller than a width in the first direction of the lower portion of each of the gate structures.

10. The semiconductor device as claimed in claim 9, further comprising a gate spacer contacting an upper surface of each of opposite edges in the first direction of the uppermost one of the semiconductor patterns,
wherein the gate spacer contacts a sidewall in the first direction of the upper portion of each of the gate structures.

11. The semiconductor device as claimed in any preceding claim, wherein each of the source/drain layers contacts a sidewall of the first division pattern.

12. The semiconductor device as claimed in any preceding claim, wherein the first division pattern extends through the insulation structure.

13. A semiconductor device comprising:
gate structures on a substrate, the gate structures being disposed in a second direction substantially parallel to an upper surface of the substrate, and each of the gate structures including a gate insulation pattern and a gate electrode;
source/drain layers at opposite sides, respectively, of each of the gate structures in a first direction that is substantially parallel to the upper surface of the substrate and that intersects the second direction;
semiconductor patterns disposed in a third direction substantially perpendicular to the upper surface of the substrate, the semiconductor patterns extending through each of the gate structures and contacting the source/drain layers;
a first division pattern between the gate structures; and
a connection pattern contacting an upper surface of the first division pattern and upper surfaces of portions of the gate structures that are adjacent to the upper surface of the first division pattern,
wherein the gate insulation pattern extends in the third direction, covers an upper surface and a lower surface of each of the semiconductor patterns, a sidewall in the second direction of each of the semiconductor patterns and a sidewall of a portion of the first division pattern between the semiconductor patterns, and
wherein the gate insulation pattern contacts a lower surface of the connection pattern.

14. The semiconductor device as claimed in claim 13, further comprising a contact plug on each of the source/drain layers,
wherein an upper surface of the connection pattern is substantially coplanar with an upper surface of the contact plug.

15. The semiconductor device as claimed in claim 14, further comprising:
a capping pattern on the gate structures; and
a gate spacer on sidewalls of the gate structures and the capping pattern,
wherein the connection pattern extends through the capping pattern.
